(19) Europäisches Patentamt
European Patent Office
Office européen des brevets

(11) **EP 3 454 187 B1**

(12) **EUROPÄISCHE PATENTSCHRIFT**

(45) Veröffentlichungstag und Bekanntmachung des Hinweises auf die Patenterteilung:
**21.02.2024 Patentblatt 2024/08**

(21) Anmeldenummer: **18194004.0**

(22) Anmeldetag: **12.09.2018**

(51) Internationale Patentklassifikation (IPC):
**G06F 3/042** (2006.01)   **G06V 10/94** (2022.01)
**G06V 10/98** (2022.01)   **G06V 40/13** (2022.01)
**G06V 40/60** (2022.01)

(52) Gemeinsame Patentklassifikation (CPC):
**G06F 3/042; G06V 10/95; G06V 10/993;
G06V 40/1318; G06V 40/1324; G06V 40/67**

(54) **ANORDNUNG ZUR OPTISCHEN AUFNAHME VON LEBENDEN HAUTBEREICHEN MENSCHLICHER AUTOPODIEN UND VON DOKUMENTEN**

ARRANGEMENT FOR OPTICAL RECORDING OF LIVING SKIN AREAS OF HUMAN AUTOPODIA AND DOCUMENTS

DISPOSITIF D'ENREGISTREMENT OPTIQUE DE ZONES CUTANÉES VIVANTES D'AUTOPODES HUMAINS ET DOCUMENTS

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **12.09.2017 DE 102017008710**

(43) Veröffentlichungstag der Anmeldung:
**13.03.2019 Patentblatt 2019/11**

(73) Patentinhaber: **Dermalog Jenetric GmbH
07749 Jena (DE)**

(72) Erfinder:
• **REINHOLD, Jörg
07743 Jena (DE)**
• **DIENER, Christoph
07743 Jena (DE)**
• **WOLFER, Roberto
07749 Jena (DE)**

(74) Vertreter: **Gleim Petri Patent- und Rechtsanwaltspartnerschaft mbB
Neugasse 13
07743 Jena (DE)**

(56) Entgegenhaltungen:
**EP-A1- 3 142 043**   **WO-A1-2017/095880**
**US-A1- 2016 110 025**   **US-A1- 2016 294 557**

• **Ilya Grigorik: "Image Optimization", , 28. Juli 2017 (2017-07-28), XP055521150, Gefunden im Internet:
URL:http://web.archive.org/web/20170731194015/https://developers.google.com/web/fundamentals/performance/optimizing-content-efficiency/image-optimization [gefunden am 2018-11-05]**

## Beschreibung

Die Erfindung betrifft eine Anordnung und ein Verfahren zur optischen Aufnahme von lebenden Hautbereichen menschlicher Autopodien und von Dokumenten. Sie findet insbesondere zur Personenidentifikation im internationalen Grenzverkehr und im Bereich der Flugsicherheit Anwendung, aber auch beispielsweise in Einzelhandelsgeschäften bei Kreditkartenzahlung.

Die Erfassung und Identifikation von Personen gewinnt stetig an Bedeutung. An internationalen Grenzübergängen zum Beispiel ist die Kontrolle von Identitätsdokumenten (ID-Dokumenten) essentiell. Zunehmend werden dabei auch Fingerabdrücke von mehr als einem Fingerglied aufgenommen und mit Datenbanken verglichen.

Ein Szenario der Grenzkontrolle ist das Passieren der Grenze mit einem Auto. Für alle Insassen des Autos sollen in naher Zukunft jeweils alle 10 Fingerabdrücke aufgenommen werden. Dabei soll mindestens die Aufnahme von vier Fingern (ohne Daumen) einer Hand gleichzeitig erfolgen, um Fehler bei der Aufnahmereihenfolge (und somit bei der Zuordnung des Bildes zum jeweiligen Finger) zu verhindern. Darüber hinaus verspricht eine gleichzeitige Aufnahme mehrerer Finger einen schnelleren Durchlauf der Prozedur als bei aufeinander folgenden Aufnahmen. Ebenso soll ein Bild vom Führerschein oder einem anderen Personaldokument (ID-Dokument) aufgenommen werden.

Unter Verwendung von Anordnungen bzw. Vorrichtungen, die aus dem Stand der Technik bekannt sind, müssen die Insassen aussteigen und an einem stationären Gerät im Grenzhäuschen ihre Fingerabdrücke abgeben. Hierbei können Anordnungen verwendet werden, wie sie auch bei anderen Grenzübergangsszenarien, wie z.B. an internationalen Flughäfen, eingesetzt werden. Es kommen meist stationäre Fingerabdrucklesegeräte und zusätzliche Dokumentenlesegeräte zum Einsatz. Im Stand der Technik gibt es allerdings auch schon Vorrichtungen, die Dokumente und Fingerabdrücke mit ein und derselben Vorrichtung aufnehmen können (DE 10 2015 116 026 A1). Dadurch kann Zeit bei der Aufnahmeprozedur gespart werden. Durch die Aufnahme von Dokumenten und Fingerabdrücken nacheinander über dieselbe Auflagefläche werden Verwechslungen durch fehlerhafte Zuordnung mehrerer Auflageflächen vermieden. Eine Vorrichtung, die sowohl Fingerabdrücke als auch Dokumente lesen kann, scheint auch kostengünstiger herstellbar zu sein als zwei einzelne Vorrichtungen.

Bei dem oben beschrieben stationären Konzept zur Bildaufnahme von Fingerabdrücken und ggf. ID-Dokumenten bleibt jedoch der Nachteil bestehen, dass die Insassen das Fahrzeug verlassen müssen. Andererseits gibt es im Stand der Technik auch Konzepte für mobile Fingerabdrucklesegeräte, wie z.B. in der US 6 886 104 B1 oder US 8 036 431 B2 beschrieben, die sich dazu eignen, von den Kontrollbediensteten (z.B. Grenzbeamte) zu den aufzunehmenden Personen gebracht zu werden. Diese Geräte sind jedoch nicht für die gleichzeitige Aufnahme mehrerer Finger ausgelegt und es können auch keine Dokumente über dieselbe Auflagefläche aufgenommen werden.

Ähnliche Anforderungen wie beim Grenzübertritt mit dem Auto bestehen auch für die Vorrichtungen zur Bildaufnahme von Personenidentitätsmerkmalen in anderen Grenzübergangsszenarien, wie z.B. bei der Grenzkontrolle in einem Zug. Aber auch in anderen Anwendungsbereichen wird ein Lesegerät bevorzugt zu der Person gebracht, deren Identität aufgenommen und/oder überprüft werden soll, z.B. bei Kreditkartenzahlung in einem Einzelhandelsgeschäft, bei der Flüchtlingsregistrierung oder der Wählerregistrierung.

Offenbarte mobile Lösungen können entweder nur Fingerabdrücke (US 8 036 431 B1, US 7 190 817 B1, US 6 886 104 B1) oder nur Dokumente (US 7 245 765 B2) scannen oder, wenn sie beides können, dann nur über ein Zusammenfügen mehrerer Geräte. Eine kombinierte Aufnahme von Fingerabdrücken und Dokumenten ist als mobile Gerätelösung aus der US 7°817 821 B2 bekannt. In diesem Fall wird eine mobile Vorrichtung offenbart, die einen Dokumentenscanner, einen Fingerabdruckscanner und eine Kamera zur Gesichtsaufnahme enthält. Hier ist von einer ‚Station' die Rede, in die verschiedene einzelne Geräte integrierbar sind, es handelt sich somit um ein modulares Gerätekonzept.

In der US 2016/0110025 A1 wird ein Verfahren zur optischen Erfassung eines Fingerabdrucks oder eines Gegenstands beschrieben, bei dem ein Bildschirm mit mehreren Photosensoren, die jeweils einem Anzeigepixel zugeordnet sind, die Anzeigepixel Lichtstrahlung emittieren, die unter kleinen Abtastwinkeln von den Photosensoren erfasst wird, wobei der Abtastwinkel in einer virtuellen Spiegelebene die Größe des Anzeigepixels beschreibt. Dabei sind der durch die Dicke der Abdeckplatte des Bildschirms definierte Abstand sowie die enge räumliche Zuordnung der Licht emittierenden Anzeigepixel zu den eng benachbarten Photosensoren ein nachteiliger Kontrast begrenzender Faktor.

Ferner ist aus der US 2016/0294557 A1 ein automatisches biometrisches Registrierungsverfahren für biometrische Merkmale bekannt, bei dem auch Fingerabdruckscanner zum Einsatz kommen. Bei dem Verfahren wird mittels Prozessor, Speicher und Display in einem mobilen Kommunikationsgerätes ein automatisierter Aufnahmeablauf durchgeführt, wobei der biometrische Abdruck auf Qualität geprüft und, falls diese unzureichend ist, die Aufnahme wiederholt wird. Dabei hat das mobile System jedoch dir volle Komplexität der Qualitätsprüfung verkabelt mit an Bord. Trotz eines nutzerfreundlichen Displays ist die im Hintergrund automatisch ablaufende Prozedur von Qualitätsprüfung und daraus resultierender Wiederholungen von mehreren biometrischen Aufnahmen für ungeübte Nutzer zeitaufwändig und das Mobilgerät bleibt eher tragbar als leicht und mobil.

In der WO 2017/095880 A1 ist ein optischer Sensor zur Integration in ein Display offenbart, bei dem ein aufwändiges Blendensystem, eine Rückseitenverspiegelung einer transparenten Schicht und rückwärtig auf die Spiegelschicht gerichtete Sensorpixel die Einfallswinkel des von der Auflagefläche kommenden Lichts auf kleine Einfallswinkel beschränkt wird. Durch die Rückseitenreflexion wird die Auflösung beschränkt infolge der freizuhaltenden Blendenaperturen und eine Aufnahme von Dokumenten ist nicht beschrieben. Infolge der kleinen Detektionswinkel ist der Kontrast der Aufnahmen nicht mit denen der TIR-basierten Fingerabdruckaufnahmen vergleichbar.

Keine der vorbenannten technischen Lösungen kann Dokumente und mehrere Fingerabdrücke mit hohem Kontrast durch einen einzigen optischen Scanner aufnehmen und ist dabei als handliches portables Gerät drahtlos für Datenbankabgleiche und Hintergrundüberprüfungen zur Personenidentifikation anwendbar.

Der Erfindung liegt die Aufgabe zugrunde, eine neue Möglichkeit zur optischen Aufnahme von lebenden Hautbereichen menschlicher Autopodien und von Dokumenten zur Personenidentifikation zu finden, die eine flexible ortsunabhängige Bildaufnahme von Fingerabdrücken und/oder Personaldokumenten, insbesondere beim mobilen Grenzübertritt im internationalen Reiseverkehr, bei der Kontrolle der Flugsicherheit, bei der Flüchtlingsidentifikation oder anderen Situationen von Personenidentifikationen, gestattet.

Erfindungsgemäß wird die Aufgabe mit einer Anordnung nach Anspruch 1 gelöst.

Vorteilhafte Ausgestaltungen ergeben sich aus den Unteransprüchen.

Ein mobiles Bildaufnahmegerät ist dabei so zu verstehen, dass dieses völlig autark, insbesondere kabellos für Bildaufnahmen von Hautabdrücken und personengebundenen Dokumenten (insbesondere ID-Dokumenten, Visa, Kreditkarten etc.) verwendbar und zwecks Datenweitergabe drahtlos mit einem weiteren elektronischen Gerät verbunden ist. Mit dem Bildaufnahmegerät werden Bilder von Dokumenten und Hautbereichen menschlicher Autopodien auf derselben Aufnahmefläche aufgenommen und ohne grundlegende Bilddatenverarbeitung an das verbundene weitere elektronische Gerät gesendet. Erst durch das verbundene weitere elektronische Gerät werden die Bilder weiterverarbeitet und bewertet und Bewertungsergebnisse an das Bildaufnahmegerät zurückgesendet, um nur qualitativ gute Bilder an das verbundene weitere elektronische Gerät zu übertragen, dort zu verarbeiten und zu speichern oder an Datenbanken oder Speichersysteme weiterzuleiten.

Mit der erfindungsgemäßen Anordnung ist es möglich, gleichzeitig mehrere Finger zu scannen. Die aktive Scanfläche lässt es zu, gleichzeitig einen Vier-Finger-Abdruck aufzunehmen. Außerdem können wahlweise über dieselbe Auflagefläche auch Dokumente aufgenommen werden, wie z.B. Personaldokumente (ID-Dokumente, Führerscheine oder Bordkarten). Das Bildaufnahmegerät für Autopodien und Dokumente ist dabei -

vergleichen mit Geräten aus dem Stand der Technik - wesentlich leichter und kleiner. Es besitzt vorzugsweise eine Dicke <5 cm und ein Gewicht <500 g. Dies wird möglich, indem ein optischer Direktscanner mit einer großflächigen Sensorschicht verwendet wird, bei dem das aufzunehmende Objekt (Finger, Vierfinger, Hand oder Dokument) auf eine Auflagefläche direkt über dem lichtempfindlichen Sensorarray aufgelegt wird und somit keine Prismen, Abbildungsoptiken und Beleuchtungsoptiken notwendig sind. Die erfindungsgemäße Anordnung verfügt über einen Akku bzw. eine Batterie, um von der kabelgebundenen Stromzufuhr mindestens für einen vorgegebenen Zeitraum unabhängig zu sein. Außerdem tauscht sie drahtlos (z.B. über WLAN, Bluetooth oder ähnliche Verbindungen) mit einem anderen Gerät Daten aus und kann somit gänzlich kabellos im mobilen Einsatz hochaufgelöste Bilder aufnehmen, diese zur Auswertung weitersenden und wiederum Ergebnisse zugesendet bekommen. Das Gerät ist mit einem Display ausgestattet, das sich neben oder innerhalb der Auflagefläche befindet, um Nutzerinformationen anzuzeigen. Auf diesem Display kann bevorzugt auch unterschrieben werden, wobei die Unterschrift dabei elektronisch registriert und ebenfalls mit versendet werden kann.

Mit der Erfindung ist es somit möglich, den gesamten Arbeitsablauf der Datenerfassung für mobile Kontroll- und Identifikationsszenarien wie Grenzübergang, Flüchtlingskontrolle, Wählerregistrierung, Boarding im Flughafen etc., derart durchzuführen, dass die zu identifizierenden Personen nicht einen stationären Kontrollposten zu Fuß durchlaufen müssen, sondern innerhalb eines Fahrzeugs (z.B. Auto oder Zug) oder an wechselnden Orten der Kontrolle (Boarding am Flughafen, Personenaufnahme in Flüchtlingsunterkünften) mit einem handlichen mobilen Gerät identifiziert werden können. Hierzu gehört u.U. eine Zehn-Finger-Aufnahme (4-4-2), Dokumentenaufnahme, Aufnahme der Unterschrift und direkte Überprüfung der Personenidentität durch Datenabgleich mit einer Datenbank.

Die Erfindung soll nachfolgend durch Ausführungsbeispiele näher beschrieben werden. Die Zeichnungen zeigen:

Fig. 1:      eine erste und eine zweite Ausführung der erfindungsgemäßen Anordnung mit einem Bildaufnahmegerät und einem Mobiltelefon oder einem Tablet-PC,

Fig. 2:      eine dritte bevorzugte Ausführung der erfindungsgemäßen Anordnung mit einem Bildaufnahmegerät und einem üblichen PC mit Bildschirm und Internetzugang,

Fig. 3:      eine vorteilhafte Ausführung des Bildaufnahmegerätes mit einer Auflagefläche, die zugleich auch als Display für die Benutzerführung ausgelegt ist,

Fig. 4: eine erste Ausführung des Schichtkörpers als eine Sensoreinheit unterhalb der Auflagefläche mit einer einheitlichen Leuchtschicht für die Beleuchtung der aufgelegten Objekte,

Fig. 5: eine weitere Ausführung des Schichtkörpers als Sensoreinheit mit einer Leuchtschicht mit zwei unterschiedlichen Lichtquellen, wobei eine Lichtquelle zur Beleuchtung von Autopodien als Wellenleiterstruktur ausgeführt ist,

Fig. 6: eine weitere Ausführung des Schichtkörpers als Sensoreinheit mit einer Leuchtschicht mit zwei unterschiedlichen Lichtquellen, wobei eine Lichtquelle zur Beleuchtung von aufgelegten Dokumenten als diffus abstrahlende Hintergrundbeleuchtung ausgeführt ist,

Fig. 7: eine weitere Ausführung des Schichtkörpers als Sensoreinheit mit einer Leuchtschicht für die Beleuchtung der aufgelegten Objekte in Form einer Wellenleiterstruktur mit zusätzlicher Reflektorschicht,

Fig. 8: eine Darstellung des Schichtkörpers entsprechend Fig. 7 zur Erläuterung des Einflusses des Umgebungslichts (Sonne),

Fig. 9: eine weitere Ausführung des Schichtkörpers als Sensoreinheit mit einer Leuchtschicht für die Beleuchtung der aufgelegten Objekte unter Verwendung einer Reflektorschicht und einer Umgebungslichtblende,

Fig. 10: eine Darstellung des Schichtkörpers entsprechend Fig. 9 zur Erläuterung des Einflusses des Umgebungslichts bei eingesetzter Umgebungslichtblende,

Fig. 11: ein typisches Ablaufschema für eine Personenidentitätsprüfung gemäß der Erfindung mit separater Bildaufnahme sowie Qualitäts- und Identitäts- bzw. Gültigkeitsprüfung von aufgenommenen Bilddaten,

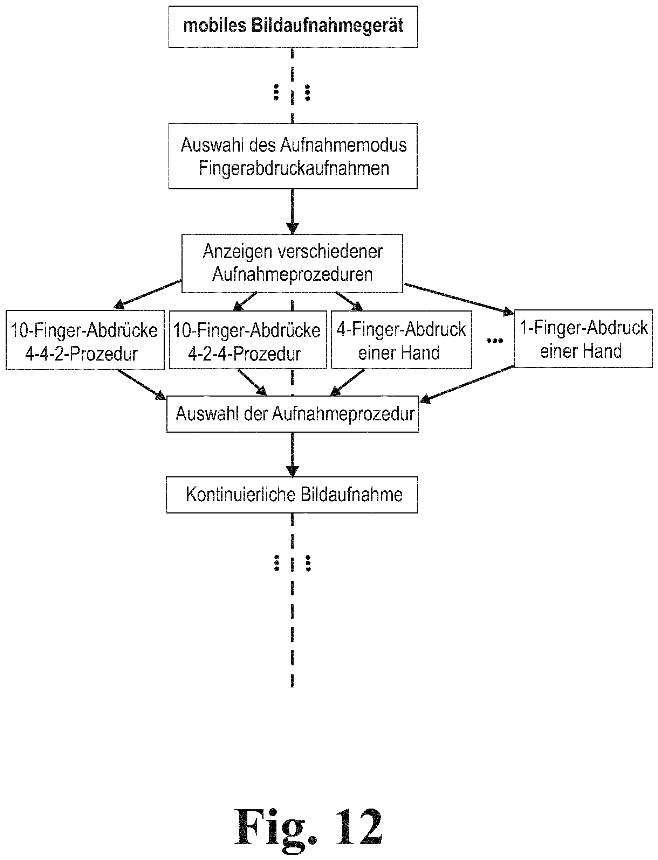

Fig. 12: eine Darstellung des Ablaufschemas für die Bildaufnahme von Autopodien in unterschiedlichen Auflageprozeduren mit Auswahlanzeige zur Nutzerführung auf dem Display des mobilen Bildaufnahmegerätes.

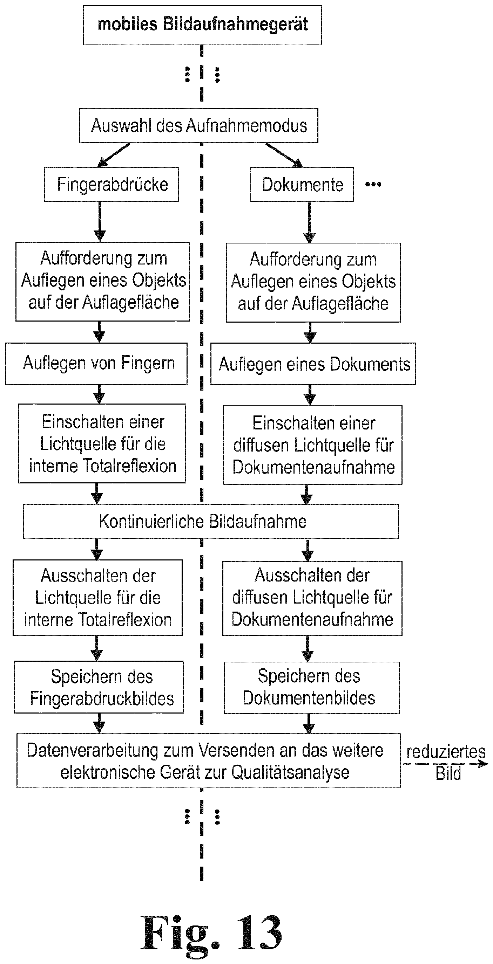

Fig. 13: eine Darstellung des Ablaufschemas für die Bildaufnahme von Autopodien und Dokumenten mit Auswahlanzeigen zur Nutzerführung auf dem Display des mobilen Bildaufnahmegerätes.

Fig. 14: eine stilisierte Darstellung des Ablaufschemas für die Weiterverarbeitung der Bildaufnahmen von Autopodien und Dokumenten und Kommunikation zwischen mobilem Bildaufnahmegerät, weiterem elektronischen Gerät und einer Datenbank.

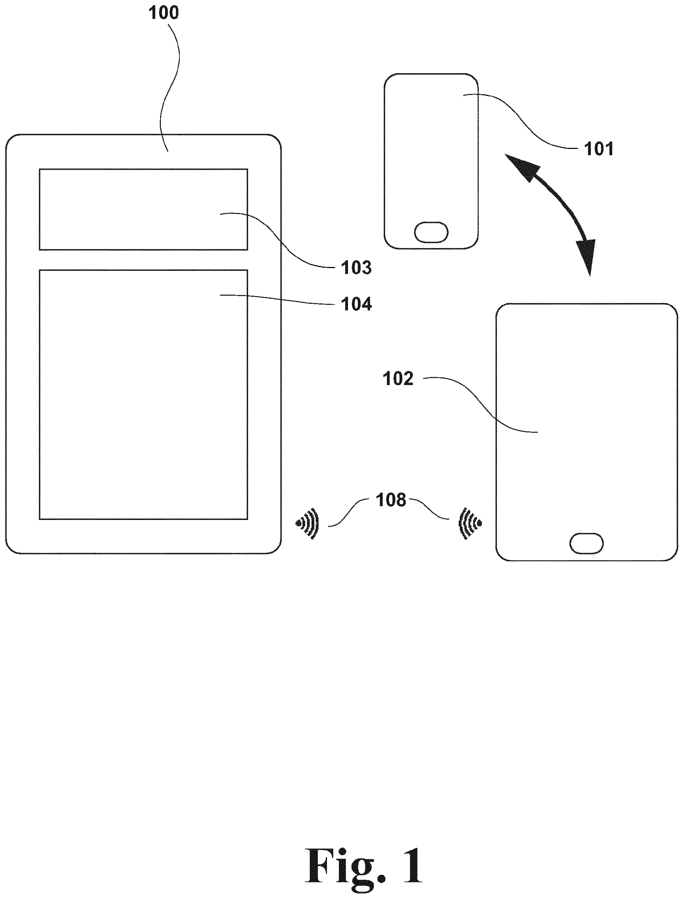

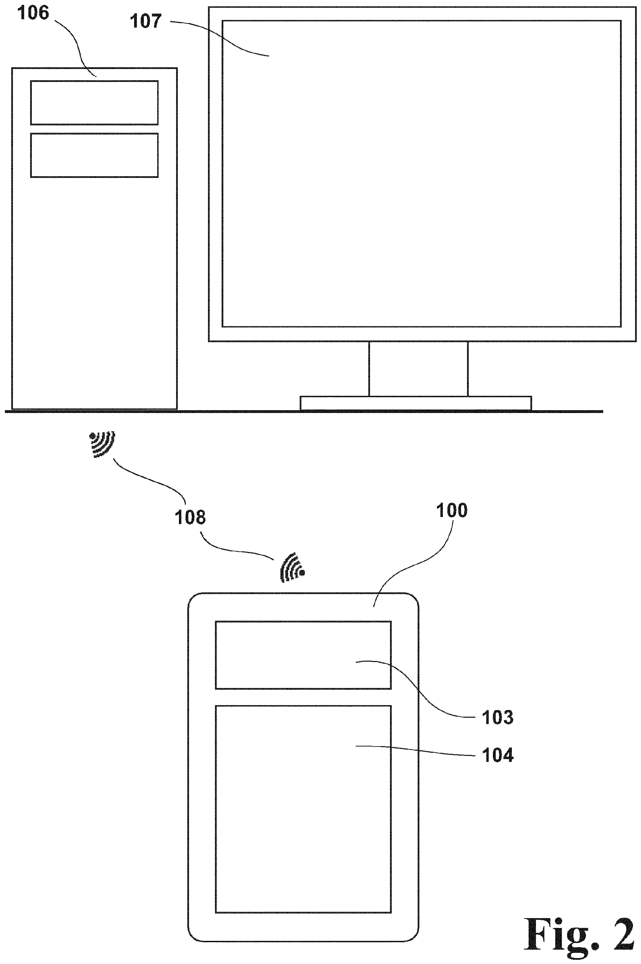

Die erfindungsgemäße Anordnung besteht aus einem mobilen Bildaufnahmegerät 100, wie in Fig. 1 gezeigt, das mit einem weiteren elektronischem Gerät drahtlos verbunden ist. Ein geeignetes Gerät, mit dem sich das Bildaufnahmegerät 100 verbinden kann, ist z.B. ein Mobiltelefon (Smartphone) 101, ein Tablet-PC 102 oder auch, wie in Fig. 2 gezeigt, ein stationärer Computer (PC) 106. Auch eine Verbindung zwischen dem Bildaufnahmegerät 100 und einen Laptop ist möglich.

Fig. 1 zeigt das mobile Bildaufnahmegerät 100 mit einer Auflagefläche 104 für die Auflage von Autopodien 112 oder Dokumenten 113. Gezeigt ist eine bevorzugte Ausführungsform mit einem separaten Display 103 für eine Nutzerführung. Das mobile Bildaufnahmegerät 100 kommuniziert über eine drahtlose Verbindung 108 mit einem oder mehreren weiteren elektronischen Geräten. In zwei bevorzugten Ausführungsformen wird das mobile Bildaufnahmegerät 100 entweder mit einem Smartphone 101 (Mobiltelefon) oder einem Tablet-PC 102 drahtlos gekoppelt.

Fig. 2 zeigt dazu eine dritte vorteilhafte Variante mit dem Bildaufnahmegerät 100 und einem gekoppelten weiteren elektronischen Gerät in Form eines internetfähigen Computers (PC) 106 mit Bildschirm 107. Die Kopplung erfolgt auch in diesem Fall durch eine drahtlose Verbindung 108. Auch die Verbindung 108 eines mobilen Bildaufnahmegerätes 100 mit mehreren PCs 106 ist möglich. Ebenso können mehrere Bildaufnahmegeräte 100 mit einem PC 106 gekoppelt sein.

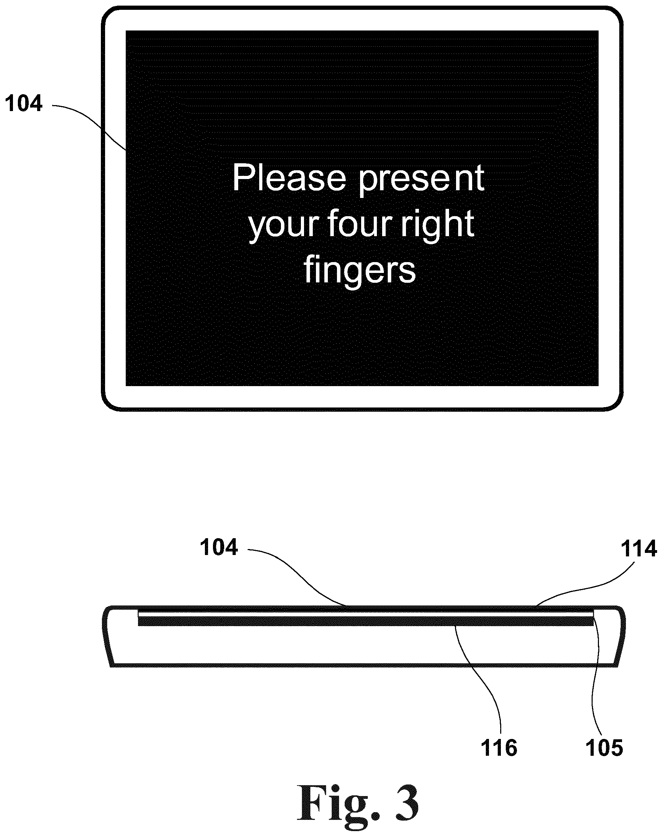

Fig. 3 zeigt ein besonders bevorzugtes Ausführungsbeispiel, bei dem das Display 103 sich unterhalb der Auflagefläche 104 befindet, unter der der Schichtkörper 105 mit Sensorschicht 115 und Leuchtschicht 116 für die direkte Bildaufnahme ohne optisch abbildende Elemente liegt. Die Nutzerführung erfolgt in dieser Ausführung direkt auf der Auflagefläche 104, wodurch sie interaktiv und kontextbasiert ausgeführt werden kann. Die Kombination mit einem weiteren Display 103, das sich neben der Auflagefläche 104, wie in Fig. 1 gezeigt, befindet, ist eine weitere Ausführungsmöglichkeit.

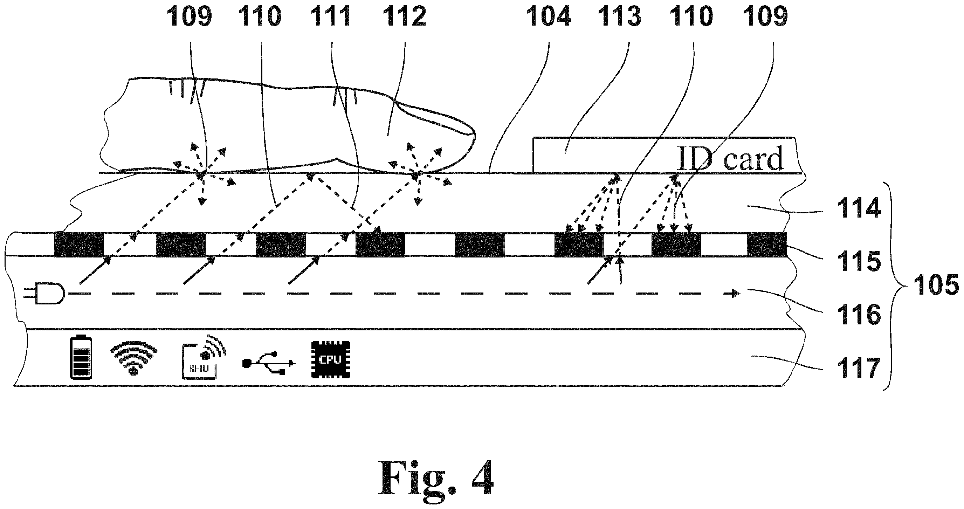

Fig. 4 zeigt den Schichtkörper 105 innerhalb des mobilen Bildaufnahmegerätes 100. Die Finger (Autopodien) 112 oder das Dokument 113 werden auf der Auflagefläche 104 aufgelegt. Die Auflagefläche 104 wird dabei durch eine Seite einer Schutzschicht 114 gebildet. Diese Schutzschicht 114 schützt die Sensorschicht 115 vor Beschädigungen durch mechanische, chemische oder elektrische Umgebungseinflüsse. Die Schutzschicht 114 und die Sensorschicht 115 sind optisch und miteinander verbunden, z.B. optisch gebondet. Auf der der Schutzschicht 114 abgewandten Seite ist die Sensorschicht 115 mit einer Leuchtschicht 116 ebenfalls optisch verbunden. Durch die Leuchtschicht 116 werden die Finger 112 oder das ID-Dokument 113 mit Beleuchtungslicht 110 beleuchtet. Der Lichtweg geht dabei durch die Sensorschicht 115 hindurch. Die Anteile des Beleuchtungslichtes 110, die an der Auflagefläche 104 einen Winkel mit dem Lot dieser Fläche einschließen, der größer ist als der Grenzwinkel der Totalreflexion, werden an der Auflagefläche 104 vollständig reflektiert. Das intern reflektierte Licht 111 kann von der Sensorschicht 115 detektiert werden. Die Berge 119 der Fingerabdrücke oder auch andere Objekte, die sich im optischen Kontakt mit der Auflagefläche 104 befinden, stören diese Totalreflexion. Dadurch kann ein inverses Bild der aufliegenden Bereiche z.B. eines Fingers 112 aufgenommen werden. Anteile des Beleuchtungslichts 110, die an der Auflagefläche 104 einen Winkel mit dem Lot dieser Fläche einschließen, der kleiner ist als der Grenzwinkel der Totalreflexion, gelangen durch die Auflagefläche 104 hindurch und können ein Objekt, z.B. ein Dokument 113, beleuchten, auch wenn es nicht im optischen Kontakt mit der Auflagefläche 104 steht. Das Streulicht 109 kann über die Sensorschicht 115 detektiert werden. Die Steuerung und Stromversorgung findet in der elektronischen Steuer- und Datenverarbeitungseinheit 117 statt. Diese verfügt über eine Schnittstelle zur drahtlosen Verbindung 108 mit einem weiteren elektronischen Gerät, z. B. Mobiltelefon 101, Tablet-PC 102 oder Computer 106. Das mobile Bildaufnahmegerät 100 wird mit dem weiteren elektronischen Gerät 101, 102 bzw. 106 drahtlos gekoppelt. In der elektronischen Steuer- und Datenverarbeitungseinheit 117 werden die Bilddaten vor dem Versenden über die drahtlose Verbindung 108 weiterverarbeitet. Beispielsweise finden hier Bildkorrekturen, Bildbewertungen, Skalierungen und Komprimieren statt. Die elektronische Steuer- und Datenverarbeitungseinheit 117 wird über einen aufladbaren Akku mit Strom versorgt, der sich innerhalb des mobilen Bildaufnahmegerätes 100 befindet. In einer bevorzugten Ausführungsform ist dieser Akku vom Benutzer wechselbar. Die Aufladung des Akkus kann z. B. über eine USB-Schnittstelle erfolgen.

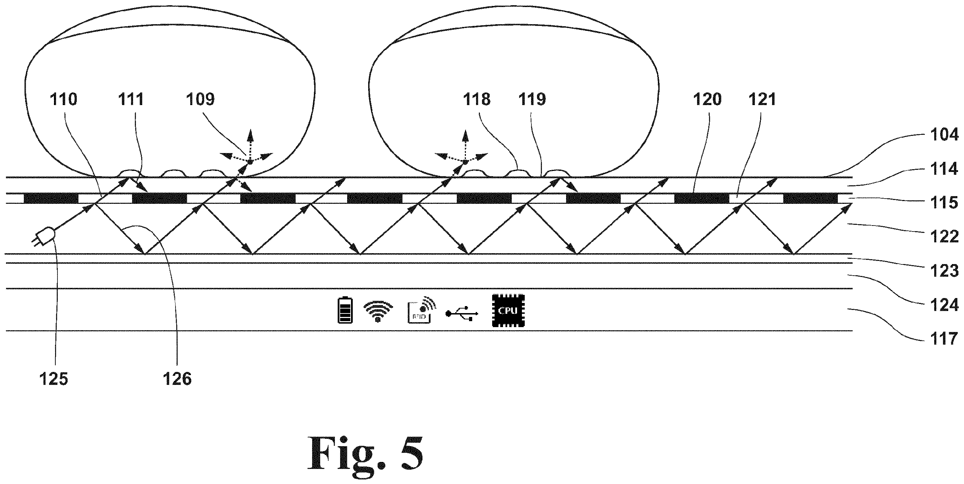

Eine besonders bevorzugte Ausführungsform ist in Fig. 5 dargestellt. Hier sind innerhalb der Leuchtschicht 116 zwei Lichtquellen vorhanden: eine Lichtquelle 122 zur Beleuchtung des Fingers 112 und eine Lichtquelle 124 zur Beleuchtung des ID-Dokumentes 113. In diesem Beispiel ist die Lichtquelle 122 zur Beleuchtung des Fingers 112 als Wellenleiter ausgeführt. Die Lichtausbreitung 126 einer Leuchtdiode 125 im Wellenleiter sorgt dafür, dass das eingekoppelte Licht sich in der gesamten Schicht der Lichtquelle 122 verteilt. Das dafür notwendige Licht kann z.B. von einer oder mehreren LEDs 125 abgestrahlt und in den Wellenleiter eingekoppelt werden. Der Wellenleiter ist hier so ausgeführt, dass Anteile des Lichtes auskoppeln und dabei durch die transparenten Bereiche 121 der Sensorschicht 115 bis zur Auflagefläche 104 gelangen.

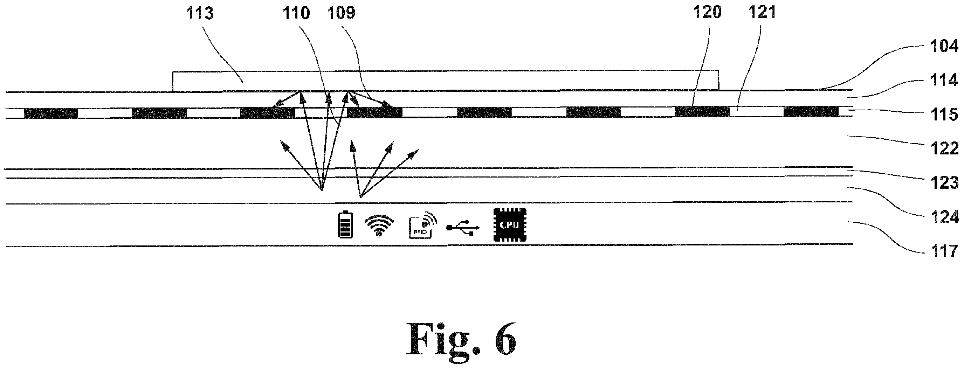

In einer weiteren zweckmäßigen Ausführungsform gemäß Fig. 6 sind innerhalb der Leuchtschicht 116 ebenfalls zwei Lichtquellen vorhanden: eine Lichtquelle 122 zur Beleuchtung des Fingers 112 und eine Lichtquelle 124 zur Beleuchtung des Dokumentes 113. In dieser Ausführungsvariante ist die Lichtquelle 124 zur Beleuchtung des Dokumentes 113 als diffuse Hintergrundbeleuchtung, wie sie z.B. auch in LCD-Displays verwendet wird, ausgeführt. Die Hintergrundbeleuchtung ist so gestaltet, dass Anteile des ausgekoppelten Beleuchtungslichtes 110 in verschiedene Richtungen austreten und dabei durch die transparenten Bereiche 121 der Sensorschicht 115 zur Auflagefläche 104 gelangen und ein dort aufgelegtes Dokument 113 beleuchten.

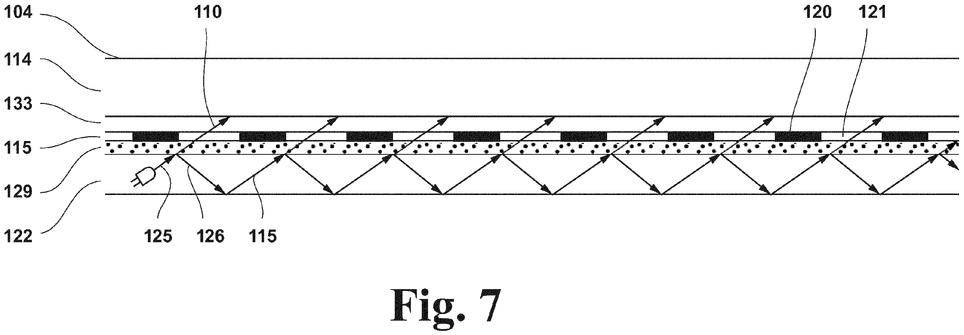

Fig. 7 zeigt den Schichtkörper 105 mit einer Lichtquelle 122 zur Beleuchtung des Fingers 112, die, wie in Fig. 5, als Wellenleiter ausgeführt ist. Zwischen der Sensorschicht 115 und der Lichtquelle 122 zur Beleuchtung des Fingers 112 befindet sich in dieser bevorzugten Ausführungsform eine Reflektorschicht 129. Diese Reflektorschicht 129 ist teilweise transparent und teilweise reflektierend, sodass Anteile des Lichtes der LEDs 125 zur Lichtausbreitung im Wellenleiter beitragen, während andere Anteile durch die Reflektorschicht 129 transmittiert werden. Das transmittierte Beleuchtungslicht 110 gelangt dabei durch die transparenten Bereiche 121 der Sensorschicht 115 bis zur Auflagefläche 104, um dort total reflektiert zu werden, solange keine direkten Kontaktflächen von aufgelegten Objekten die innere Totalreflexion stören.

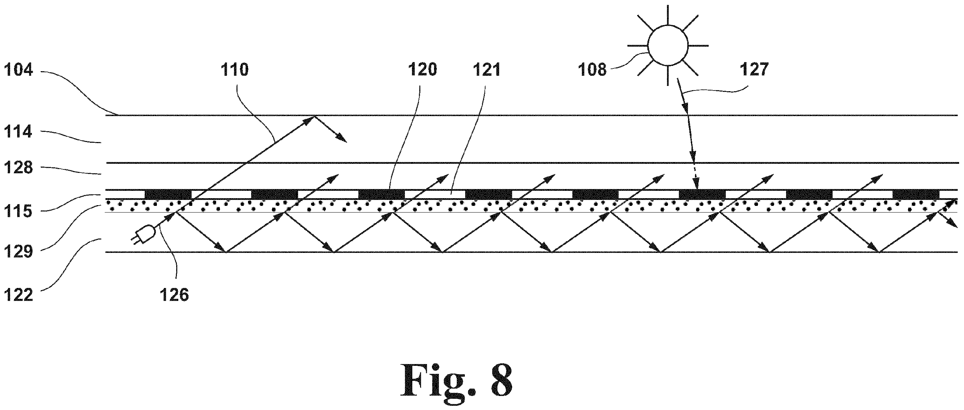

Eine weitere Ausführungsvariante gemäß Fig. 8 nutzt wie in Fig. 7 eine als Wellenleiter ausgeführte Lichtquelle 122 zur Beleuchtung des Fingers 112 sowie eine Reflektorschicht 129. Zusätzlich befindet sich hier ein Spektralfilter 128 zwischen der Schutzschicht 114 und der Sensorschicht 115. Dieses Spektralfilter 128 ist so ausgeführt, dass es Anteile des Umgebungslichtes 127, z. B. durch die Sonne, blockiert (und durch Reflexion oder Absorption ausfiltert).

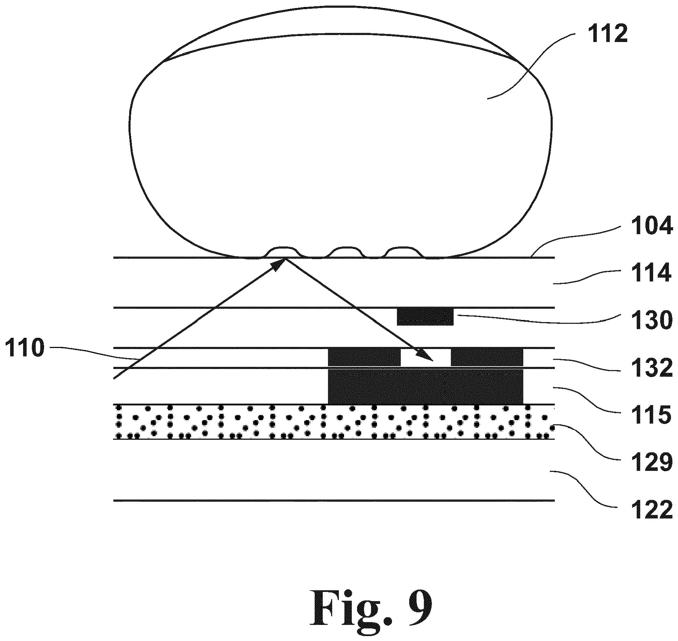

Fig. 9 zeigt einen begrenzten Abschnitt des Schichtkörpers 105, wie er in Fig. 7 dargestellt ist, mit einer als Wellenleiter ausgeführten Lichtquelle 122 zur Beleuchtung des Fingers 112 sowie mit einer Reflektorschicht 129. Zusätzlich vorhanden ist hier eine Schicht mit Umgebungslichtblenden 130. Der ausgewählte Abschnitt des Schichtkörpers 105 zeigt eine Umgebungslichtblende 130, die Licht blockiert, das sich unter bestimmten Winkeln von der Auflagefläche 104 aus in Richtung Sensorschicht 115 ausbreitet. Dabei soll das Beleuchtungslicht 110 und dessen Reflexion an der Auflagefläche 104 nicht beschränkt werden.

Aufgrund des Abstandes zwischen Umgebungslichtblende 130 und lichtsensitivem Element der Sensorschicht 115 sowie aufgrund der Größe und Form der Umgebungslichtblende 130 werden die Winkel definiert, die geblockt werden. In einer weiter verbesserten Ausführungsform gibt es eine weitere Schicht mit Pixelaperturblenden 132. Eine solche Pixelaperturblende 132 befindet sich - wie im Abschnitt von Fig. 9 einzeln gezeichnet - zwischen der Sensorschicht 115 und der Schicht mit den Umgebungslichtblenden 130. Durch die Pixelaperturblende 132 können ungewünschte Winkelbereiche noch effektiver blockiert werden.

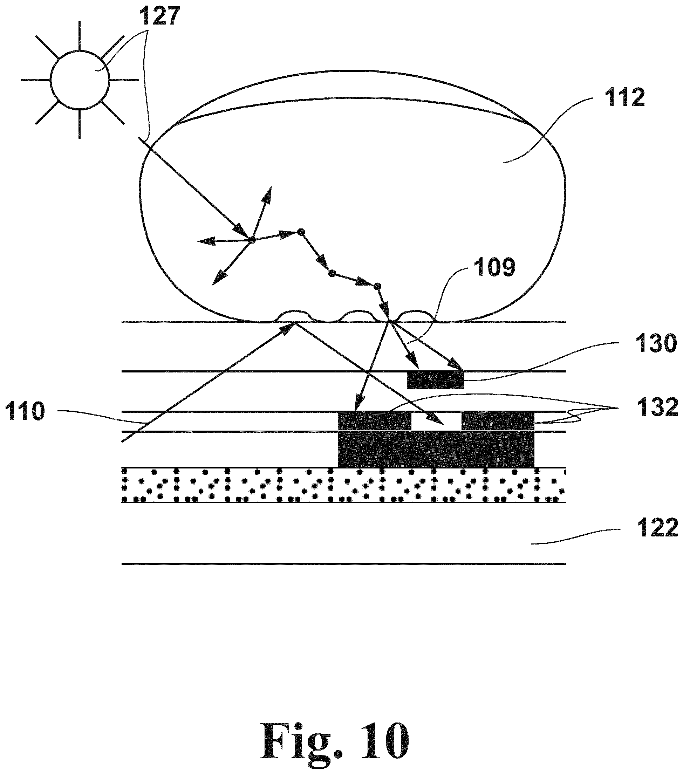

Fig. 10 zeigt einen Schichtkörper 105, wie in Fig. 9, mit winkelselektivem Umgebungslichtschutz aus Umgebungslichtblende 130 und Pixelaperturblende 132. Zur Veranschaulichung der Wirksamkeit der Umgebungslichtblende 130 und der Pixelaperturblende 132 ist hier der Lichtweg von störendem Umgebungslicht 127 eingezeichnet. Störendes Umgebungslicht 127 tritt insbesondere auf, wenn die Sonne direkt auf die Auflagefläche 104, bzw. auf den aufgelegten Finger 112, scheint. Solche Lichtanteile, die aus dem Umgebungslicht 127 stammen, werden in der Ausführungsform gemäß Fig. 9 und 10 wirksam reduziert.

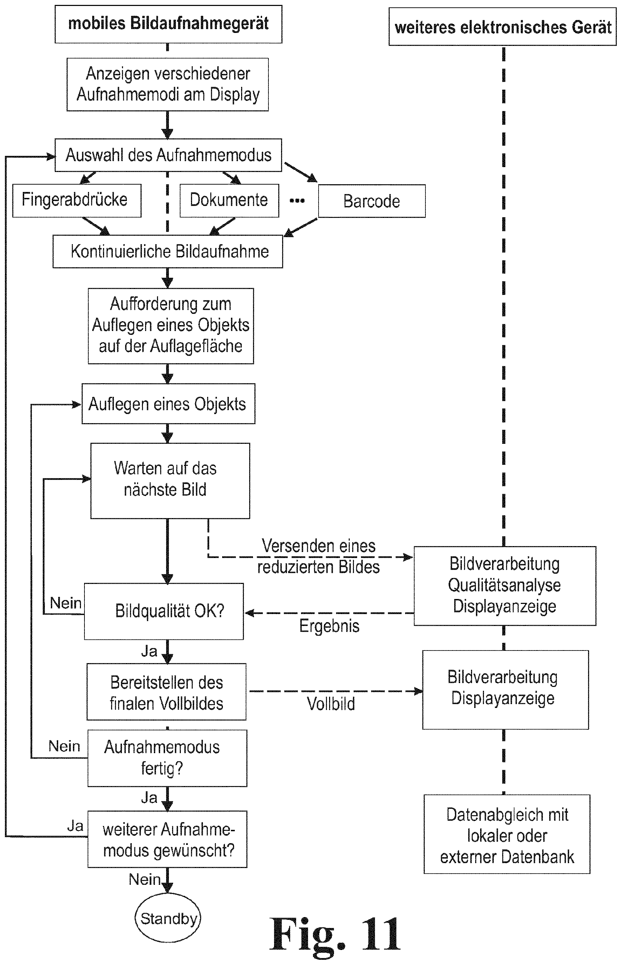

Fig. 11 zeigt ein typisches Ablaufschema für eine Personenidentitätsprüfung gemäß der Erfindung mit separater Bildaufnahme sowie Qualitäts- und Identitätsbzw.

Gültigkeitsprüfung von aufgenommenen Bilddaten. Das Verfahren wird dabei durch eine Benutzerführung auf einem Display 103 des Bildaufnahmegerätes 100 unterstützt. Der Ablauf beginnt mit der Auswahl verschiedener Aufnahmemodi, z.B. Fingerabdruckaufnahme, Dokumentenaufnahme, Unterschriftenaufnahme oder auch zur Aufnahme von Barcodes. Der Benutzer wählt daraufhin den entsprechenden Modus aus. Ist das Bildaufnahmegerät 100 so ausgeführt, dass sich das Display 103 separat neben der Auflagefläche 104 befindet, so ist es bevorzugt mit einem Touchscreen ausgestattet. Der Benutzer kann also direkt den gewünschten Modus mit dem Finger auswählen.

Befindet sich das Display 103 zur Anzeige der Benutzerinformation unterhalb der Auflagefläche 104 des Bildaufnahmegerätes 100, so kann auch die Auswahl des Benutzers mit dem Finger direkt von der Sensorschicht 115 detektiert werden. Ist die Auswahl erfolgt, zeigt das Display 103 die Varianten der Aufnahmeprozeduren an, bei Fingeraufnahme z.B. 4-4-2, also eine Prozedur, bei der zuerst 4 Finger der einen Hand, dann 4 Finger der anderen Hand und zum Schluss, in einer dritten Aufnahme, die 2 Daumen aufgenommen werden. Es gibt aber auch andere Prozeduren zur Fingerabdruckaufnahme, z.B. mit gleichzeitiger Aufnahme von nur zwei Fingern. Befindet sich das Gerät z.B. im Modus zur Dokumentenaufnahme, dann können auch unterschiedliche Prozeduren für unterschiedliche Dokumente angeboten werden. Der Benutzer wählt, wie bei der Auswahl des Modus, die gewünschte Prozedur aus. Das Bildaufnahmegerät 100 schaltet nun die Beleuchtung zur Aufnahme ein und startet den kontinuierlichen Bildeinzug. Im Allgemeinen kann die Beleuchtung auch schon eingeschaltet sein, für reduzierten Stromverbrauch im mobilen Szenario bietet sich jedoch an, die Beleuchtung nur für die Aufnahme einzuschalten. Bevorzugt sind separate Lichtquellen 124, 122 für die Beleuchtung von Dokumenten 113 und Autopodien 112 in der Leuchtschicht 116 enthalten. Das Bildaufnahmegerät 100 schaltet die Beleuchtung ein, die für den ausgewählten Aufnahmemodus gebraucht wird. Das Display 103 fordert nun den Benutzer entsprechend der ausgewählten Prozedur auf, das Dokument 113 oder einen oder mehrere Finger 112 auf die Auflagefläche 104 zu legen. Während des kontinuierlichen Bildeinzuges werden fortwährend Bilder mit der Sensorschicht 115 aufgenommen und mit der elektronischen Steuer- und Datenverarbeitungseinheit 117 zwischengespeichert und reduziert. Die reduzierten Bilder werden an ein mit dem Bildaufnahmegerät 100 verbundenes elektronisches Gerät fortwährend gesendet. In einem typischen Szenario ist - gemäß Fig. 1 - dieses verbundene Gerät ein Mobiltelefon 101 oder ein Tablet-PC 102. Das verbundene elektronische Gerät empfängt die Daten und startet Bildverarbeitungsprozesse.

Insbesondere werden dabei die Bilder bewertet. Typische Bewertungsverfahren testen das Bildrauschen, den Kontrast oder den Grauwertumfang. Während dieser Prozedur werden die reduzierten Bilder bevorzugt kontinuierlich auf dem Display des verbundenen Gerätes angezeigt. Die Aufnahme kann so über das verbundene Gerät überwacht werden. Das Ergebnis des Qualitätstests wird an das Bildaufnahmegerät 100 zurückgesendet. Ist das Ergebnis positiv, sendet das Bildaufnahmegerät 100 das entsprechende Vollbild an das verbundene Gerät (Mobiltelefon 101, Tablet-PC 102); ist der Test negativ, geht der kontinuierliche Aufnahmeprozess weiter, bis ein Bild den Qualitätstest erfüllt oder eine andere Abbruchbedingung greift. Eine Abbruchbedingung kann z.B. ein zeitliches Limit sein, nachdem der Benutzer zur Neuauflage aufgefordert wird oder Korrekturmaßnahmen zur Verbesserung der Aufnahme durchführen soll (mehr Auflagedruck, trockene Finger anfeuchten etc.).

Nachdem das Vollbild an das verbundene Gerät gesendet wurde, führt dieses eine weitere Bildverarbeitungskette aus, um das Bild für die Anforderungen zu optimieren (Filter, Transformationen etc.). Falls die Aufnahmeprozedur beendet ist, zeigt das Display 103 des Bildaufnahmegerätes 100 die Bestätigung (z.B. grünes Häkchen), falls nicht, wird auf dem Display 103 die Aufforderung zur Auflage der nächsten Finger 112 oder Dokumente 113 dargestellt und die Prozedur geht weiter, wie oben beschrieben. Der Status der Prozedur wird auch bevorzugt auf dem Display des verbundenen Gerätes dargestellt, ebenso die reduzierten Bilder und die Vollbilder sowie das Ergebnis nach Abschluss der Prozedur.

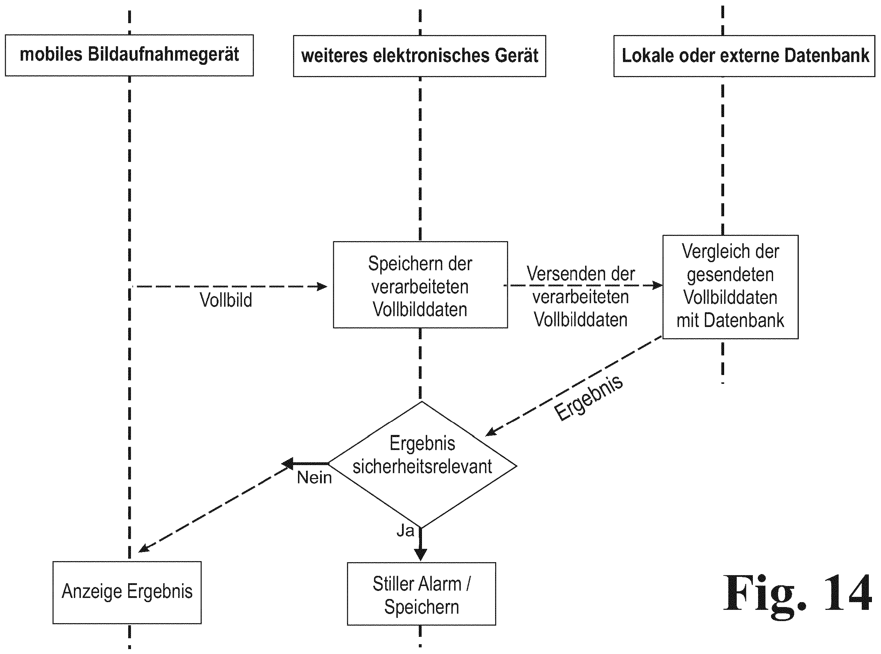

Nach Ablauf der Prozedur beginnt die Weiterverarbeitung der finalen Bilddaten. Diese werden gemäß Fig. 14 bevorzugt lokal auf dem Gerät mit einer Datenbank verglichen oder auch an eine verbundene externe Datenbank gesendet und verglichen. Das Ergebnis wird über das verbundene weitere elektronische Gerät (Mobiltelefon 101, Tablet-PC 102 oder PC 106) empfangen und dort dargestellt oder auch auf das Bildaufnahmegerät 100 versendet und dort über das Display 103 dargestellt.

Nach dem grundlegenden Verfahren, wie in Fig. 11 beschrieben, wird das weitere elektronische Gerät 101, 102 bzw. 106 die verarbeiteten Vollbilddaten speichern und danach an eine lokale Datenbank oder an eine über Netzwerk verbundene Datenbank (wie z.B. US-IDENT, EU-VIS, Kreditkartendatenbank) übermitteln. Die Daten werden dort mit den gespeicherten Datenbankeinträgen verglichen. Das Ergebnis empfängt das weitere elektronische Gerät 101, 102 bzw. 106. Ist das Ergebnis nicht belastend, z.B. die Kreditkartendaten sind in Ordnung oder der Reisende an der Grenze wird nicht strafrechtlich gesucht, dann wird das Ergebnis auf dem verbundenen weiteren elektronischen Gerät 101, 102 bzw. 106 und auf dem Bildaufnahmegerät 100 dargestellt bzw. die Prozedur beendet. In Fällen, in denen ein kritisches Ergebnis gefährlich für den Operator ist, wird ein stiller bzw. verdeckter Alarm ausgelöst, z.B. bei der Grenzkontrolle im Zug: der Reisende wurde von der Datenbank als Gesucht eingestuft, dann erhält der Grenzbeamte einen Hinweis auf vorzugsweise ein Smartphone (Mobiltelefon 101) in seiner Jackentasche, z.B. ein Vibrieren. Bei dem Auto-Grenzübergang erhält der Grenzbeamte den Hinweis auf seinen PC 106, der Reisende sieht diesen Hinweis nicht.

Mit dem Bildaufnahmegerät 100 können lebende Hautbereiche menschlicher Autopodien 112 und beliebige Dokumente 113, insbesondere aber ID-Dokumente, über eine Auflagefläche 104 aufgenommen werden. Das Bildaufnahmegerät 100 wird dabei z.B. von einem Polizisten oder Grenzbeamten z.B. dem Reisenden, dessen Identität aufgenommen werden soll, entgegengehalten oder ihm ausgehändigt, z.B. in das Innere eines Autos. Das Bildaufnahmegerät 100 besitzt mindestens ein Display 103, das sich, wie in Fig. 1 gezeigt, neben der Auflagefläche 104 befinden kann. In einer bevorzugten Variante, wie in Fig. 3 gezeigt, kann sich ein Display 103 aber auch unterhalb der Auflagefläche 104 befinden. Die über das Display 103 dargestellte Information ist dann direkt auf der Auflagefläche 104 zu sehen.

Ein Querschnitt durch das Bildaufnahmegerät 100 ist in Fig. 4 gezeigt. Der wesentliche Bestandteil ist ein Schichtkörper 105, bestehend aus einer Schutzschicht 114, die die Auflagefläche 104 bildet, einer Sensorschicht 115 und einer Leuchtschicht 116. Das Bildaufnahmegerät 100 besitzt außerdem eine elektronische Steuer- und Datenverarbeitungseinheit 117.

Auf einem Display 103 des Bildaufnahmegerätes 100 erscheint zu Beginn der Aufnahmeprozedur eine Aufforderung zur Auflage der entsprechenden Autopodien 112 oder zur Auflage eines Dokumentes 113.

Autopodien 112 beziehen sich hier insbesondere auf menschliche Finger. Bei der Aufnahme sogenannter flacher Fingerabdrücke werden idealerweise die Abdrücke aller drei Fingerglieder aufgenommen, mindestens werden die Hautabdrücke des dritten Fingergliedes erfasst. Bei gerollten Fingerabdrücken wird das dritte Fingerglied flach seitlich aufgelegt und dann über die Auflagefläche 104 abgerollt.

Dokumente 113 sind hier in erster Linie Identitätsdokumente (ID-Dokumente), wie z.B. der Deutsche Personalausweis. In den USA wird üblicherweise der Führerschein verwendet. Ein Dokument 113 kann hier aber auch eine Bordkarte für ein Flugzeug, eine Eintrittskarte oder ein Barcode sein, der sich z.B. auf einem Ausdruck oder einem anderen Gegenstand befindet.

Bevor die Bildaufnahme erfolgt, wird die Beleuchtung in Form der Leuchtschicht 116 des Schichtkörpers 105 zur Bildaufnahme eingeschaltet. Das Einschalten kann vor oder nach der Auflage der Autopodien 112 oder des Dokuments 113 erfolgen. Für die Aufnahme der Autopodien 112 und die Aufnahme der Dokumente 113 können im Allgemeinen verschiedene Lichtquellen 122 oder 124 im Bildaufnahmegerät 100 vorhanden sein. Je nachdem, welches Objekt aufgenommen werden soll, wird die entsprechende Lichtquelle 122 oder 124 in der Leuchtschicht 116 eingeschaltet bzw. die Lichtquellen 122, 124 umgeschaltet.

Schichtkörper

Das Bildaufnahmegerät 100 besitzt einen Schichtkörper 105, wie er in Fig. 4 gezeigt ist, und enthält eine Sensorschicht 115, eine darüber liegende Schutzschicht 114, die nach außen die Auflagefläche 104 bildet, und darunter wenigstens eine Leuchtschicht 116, die Lichtquellenanteile zur Beleuchtung von Autopodien 112 und Dokumenten 113 aufweist, sowie eine Schicht zur Unterbringung einer elektronischen Steuer- und Datenverarbeitungseinheit 117.

Die Bildaufnahme erfolgt mittels einer Sensorschicht 115, die von einer Schutzschicht 114 gegen Umwelteinflüsse geschützt wird. Die Schutzschicht 114 bildet nach außen die Auflagefläche 104. Unterhalb der Sensorschicht 115 befindet sich mindestens eine Leuchtschicht 116. Für die Bildaufnahme von Hautbereichen von Autopodien 112 wird Licht in einem definierten Winkelbereich aus der Leuchtschicht 116 ausgekoppelt. Dieses Licht breitet sich durch die Sensorschicht 115 und die Schutzschicht 114 hindurch bis zur Auflagefläche 104 aus. Die Auflagefläche 104 ist eine optische Grenzfläche zwischen verschiedenen Materialen: einerseits dem Material der Schutzschicht 114 und andererseits dem Material der Umgebung des Bildaufnahmegerätes 100 oder dem Material des aufgelegten Objektes, das sich auf der Auflagefläche 104 befindet. An dieser optischen Grenzfläche gibt es Reflexion und Transmission. Teile des Beleuchtungslichtes 110 der Leuchtschicht 116 werden an der durch die Auflagefläche 104 gebildeten Grenzfläche reflektiert und können von der Sensorschicht 115 detektiert werden.

Andere Anteile des Beleuchtungslichtes 110 passieren die von der Auflagefläche 104 gebildete Grenzfläche. Liegt kein Objekt, Finger 112 oder Dokument 113, auf der Auflagefläche 104 auf, gelangt dieses transmittierte Licht in die Umgebung. Liegt ein Finger 112 oder Dokument 113 auf der Auflagefläche 104 auf, so wird das Beleuchtungslicht 110 von diesem zurück reflektiert bzw. zurück gestreut. Das so rückgestreute bzw. reflektierte Streulicht 109 kann wiederum von der Sensorschicht 115 detektiert werden.

Lichtquellen

Für die Aufnahme von Hautabdrücken wird hier das Prinzip der gestörten internen Totalreflexion verwendet, das Prinzip ist in Fig. 5 gezeigt. Die Lichtquelle 122 zur Beleuchtung von Autopodien 112 strahlt Beleuchtungslicht 110 in einem beschränkten Winkelbereich um eine Vorzugsrichtung ab. Die Lichtquelle 122 zur Beleuchtung von Autopodien 112 kann dabei, wie in Fig. 5 gezeigt, als Wellenleiter ausgeführt sein. Über LEDs 125 wird dabei Licht in die Leuchtschicht 116 als Wellenleiter gekoppelt. Das Beleuchtungslicht 110 wird nach den physikalischen Prinzipien der Lichtausbreitung im Wellenleiter 126 verteilt. Der Wellenleiter ist so beschaffen, dass Anteile des sich im Wellenleiter ausbreitenden Lichtes als Beleuchtungslicht 110 aus dem Wellenleiter hinausgelangen können.

An der Auflagefläche 104 wird das Beleuchtungslicht 110 aufgrund des Unterschiedes des Brechungsindex zwischen der Umgebung des Bildaufnahmegerätes 100 (z.B. Luft) und der Schutzschicht 114 intern total reflektiert, falls folgende Voraussetzung erfüllt ist:

$$\theta_c = \arcsin\left(\frac{n_2}{n_1}\right)$$

$\theta_c$ ist der Winkel des Lichtes in der Schutzschicht 114, gemessen zum Lot zur Auflagefläche 104. $n_2$ ist der Brechungsindex der Umgebung des Bildaufnahmegerätes 100, bei Luft ist $n_2 = 1$, und $n_1$ ist der Brechungsindex der Schutzschicht 114. Für Floatglas (z.B. BK7) ist $n_1$ im sichtbaren Wellenlängenbereich ungefähr 1,5. Für $\theta_c$ ergibt sich somit ein Winkel von rund 42°.

Für Winkelanteile des Beleuchtungslichtes 110 größer als 42° zum Lot der Auflagefläche 104 wird das Beleuchtungslicht 110 innerhalb der Schutzschicht 114 vollständig reflektiert. Das intern reflektierte Licht 111 wird von der Sensorschicht 115 detektiert. Dies gilt, falls sich keine Hautfläche eines Autopodiums 112 an betreffender Stelle in direktem optischen Kontakt mit der Auflagefläche 104 befindet. Dies ist an den Stellen der Fall, an denen kein Finger 112 aufliegt, dies ist aber auch an Tälern 118 des Fingerabdruckprofils der Fall. Trifft das Beleuchtungslicht 110 jedoch auf einen Berg 119 des Fingerabdruckprofils, so koppelt das Beleuchtungslicht 110 an dieser Stelle in das Hautgewebe des Fingers 112. Dort entsteht Streulicht 109. Anteile des Streulichts 109 gelangen zurück in Richtung Auflagefläche 104. Sie passieren die Auflagefläche 104 und die Schutzschicht 114 und werden von der Sensorschicht 115 detektiert. Die Intensität des Streulichts 109 vom Finger 112 auf die Sensorschicht 115 ist geringer als die Intensität des intern reflektierten Lichtes 111. Somit lässt sich ein Kontrast zwischen Berg 119 und Tal 118 des Fingerabdruckprofils abbilden.

Für die Aufnahme von Dokumenten 113, wie in Fig. 6 gezeigt, benötigt das Beleuchtungslicht 110 Anteile, die nicht an der Auflagefläche 104 intern total reflektiert werden. Diese Anteile gelangen durch die Auflagefläche 104 hindurch und erzeugen an der Oberfläche des Dokuments 113 Streulicht 109. Anteile des Streulichts 109 gelangen zurück in Richtung Auflagefläche 104. Sie passieren die Auflagefläche 104 und die Schutzschicht 114 und werden von der Sensorschicht 115 detektiert. Je nach Farbe und Helligkeit des Dokuments 113 erzeugt das Beleuchtungslicht 110 dabei an unterschiedlichen Stellen vom Dokument 113 unterschiedlich starkes Streulicht 109. Ein Bild des Dokumentes 113 (Druck, Text, Muster) kann somit aufgenommen werden.

Für die Abbildung des Fingerabdruckprofils und die Abbildung (gedruckter) flacher Dokumente 113 werden unterschiedliche Winkelbereiche des Beleuchtungslichtes 110 genutzt. Den besten Kontrast zwischen Berg 119 und Tal 118 des Fingerabdruckprofils erlangt man, wenn alle Winkelanteile des Beleuchtungslichtes 110 die Voraussetzung für interne Totalreflexion an der Auflagefläche 104 erfüllen. Die Aufnahme flacher Dokumente 113 ist dann allerdings nicht möglich. Hat das Beleuchtungslicht 110 keine Winkelanteile, die die Voraussetzung für interne Totalreflexion an der Auflagefläche 104 erfüllen, aber dafür Winkelanteile, die die Auflagefläche 104 passieren können, dann ist eine Abbildung flacher Dokumente 113 möglich, jedoch keine Aufnahme des Fingerabdruckprofils.

Die Leuchtschicht 116 kann so ausgeführt sein, dass sie sowohl Winkelanteile zur Aufnahme des Fingerabdruckprofils als auch Winkelanteile zur Aufnahme von Dokumenten 113 abstrahlt. Der in Fig. 4 gezeigte Schichtkörper 105 weist eine Leuchtschicht 116 mit nur einer Lichtquelle 122 auf, bei der dafür gesorgt ist, dass sie sowohl Lichtanteile enthält, die die Voraussetzung für interne Totalreflexion erfüllen, als auch Lichtanteile, die nicht intern total reflektiert werden. Diese Ausführungsform hat den Vorteil, dass nur eine Lichtquelle 122 nötig ist und somit Kosten, Volumen und Gewicht geringer sind als bei Ausführungsformen mit mehreren Lichtquellen.

Eine bevorzugte Ausführungsform des Bildaufnahmegerätes 100 besitzt in der Leuchtschicht 116 zwei Lichtquellen, eine eine Lichtquelle 122 zur Beleuchtung von Autopodien 112 und eine Lichtquelle 124 zur Beleuchtung von Dokumenten 113. Entsprechende Schichtkörper 105 mit einer zweigeteilten Leuchtschicht 116 aus den zwei Lichtquellen 122 und 124 sind in Fig. 5 und Fig. 6 gezeigt. Je nachdem, welches Objekt, Autopodium 112 oder Dokument 113, aufzunehmen ist, wird die entsprechende Lichtquelle 122 zur Beleuchtung von Autopodien 112 ein- und die andere Lichtquelle 124 zur Beleuchtung von Dokumenten 113 ausgeschaltet. Beide Lichtquellen 122 und 124 können jeweils bezüglich des Winkelspektrums entweder für die Dokumentenaufnahme oder für die Aufnahme der Hautabdrücke mehrteiliger Autopodien 112 optimiert werden. Die Lichtquelle 122 zur Beleuchtung von Autopodien 112 erzeugt idealerweise dann ein Beleuchtungslicht 110, das die Voraussetzung für interne Totalreflexion an der Auflagefläche 104 erfüllt. Der Kontrast zwischen Berg 119 und Tal 118 eines Hautabdruckprofils ist dann für dieses System maximal. Die Lichtquelle 124 zur Beleuchtung von Dokumenten 113 enthält idealerweise nur Winkelanteile, die die Voraussetzung für die interne Totalreflexion an der Auflagefläche 104 nicht erfüllen, sondern unter deutlich vom Totalreflexionswinkel abweichenden Austrittswinkeln abstrahlt.

Bei einer Leuchtschicht 116 mit einem System aus zwei Lichtquellen 122 und 124 muss das Licht der einen Lichtquelle 124 die andere Lichtquelle 122 passieren. In einer bevorzugten Ausführungsform, gezeigt in Fig. 5 und Fig. 6, befindet sich die Lichtquelle 122 zur Beleuchtung der Autopodien 112 direkt mit der Sensorschicht 115 verbunden und ist hinreichend transparent für das Licht der Lichtquelle 124 zur Beleuchtung der Dokumente 113. Das Licht der Lichtquelle 124 zur Beleuchtung der Dokumente 113 passiert in dieser Variante die Lichtquelle 122 zur Beleuchtung der Autopodien 112, die Sensorschicht 115, die Schutzschicht 114 und beleuchtet durch die Auflagefläche 104 hindurch das Dokument 113. Zwischen beiden Lichtquellen 122 und 124 befindet sich eine weitere Schicht, z.B. ein Luftspalt 123, mit kleinerem Brechungsindex als dem der als Wellenleiter ausgebildeten Lichtquelle 122 zur Beleuchtung der Autopodien 112. Wird ein Wellenleitersystem als Lichtquelle 122 zur Beleuchtung der Autopodien 112 verwendet, stellt der Luftspalt 123 sicher, dass dieser Wellenleiter nicht gestört wird, also kein Licht an der der Sensorschicht 115 abgewandten Seite auskoppelt.

Homogenisierung

In einer besonders bevorzugten Ausführungsform wird ein Wellenleiter als Lichtquelle 122 zur Beleuchtung der Autopodien 112 verwendet. Damit Licht der Lichtquelle 122 zur Beleuchtung der Autopodien 112 in Richtung der Auflagefläche 104 auskoppeln kann, um diese zu beleuchten, befindet sich in einer Ausführungsvariante ein Reflektor 129 zwischen Sensorschicht 115 und der Lichtquelle 122 zur Beleuchtung der Autopodien 112. Dieses Konzept ist in Fig. 7 gezeigt. Die Reflektorschicht 129 bildet somit eine weitere Schicht des Schichtkörpers 105 und ist sowohl mit der Sensorschicht 115 als auch mit der Lichtquelle 122 zur Beleuchtung der Autopodien 112 optisch gekoppelt.

Wenn zwei Schichten optisch gekoppelt sind, heißt das, dass sich kein Luftspalt zwischen ihnen befindet. Falls beide Schichten miteinander verklebt oder über einen anderen Fügeprozess miteinander verbunden sind, und sich dadurch ein zusätzliches Material (z.B. Kleber) zwischen den beiden Schichten befindet, so hat dieses Material einen Brechungsindex zwischen dem der beiden Schichten, bzw. sein Brechungsindex ist ähnlich dem der beiden Schichten.

Der Reflektor 129 ist so ausgeführt, dass er einen Teil des Lichtes reflektiert und einen Teil transmittiert. Somit kann ein Teil des Beleuchtungslichtes 110 sich weiter in der Leuchtschicht 116, die somit als Wellenleiter wirkt, ausbreiten, während der andere Teil durch Schichtkörper 105 hindurch die Auflagefläche 104 beleuchtet. Der Reflexionsgrad des Reflektors 129 sollte mindesten 50% sein, die Transmission größer als 5%. Eine solche Reflektorschicht 129 kann z.B. als Metallschicht ausgeführt sein. Damit der Transmissionsgrad der metallischen Reflektorschicht 129 hinreichend groß ist, muss die Metallschicht hinreichend dünn sein. Eine Dicke von wenigen Nanometern bis hin zu einigen 10 Nanometern erfüllt diese grundlegenden Reflexions- und Transmissionsvoraussetzungen für gängige Metalle (z.B. Silber, Gold, Aluminium, Messing, Kupfer).

In einer besonders bevorzugten Ausführungsform kann das Verhältnis aus Reflexions- und Transmissionsgrad der Reflektorschicht 129 nicht durch die Dicke, sondern durch die Struktur einer Metallschicht definiert sein. In dieser Variante ist die metallische Reflektorschicht 129 mindestens einige 10 Nanometer dick und deren Transmissionsgrad somit kleiner 1%. Eine solche Reflektorschicht 129 weist aber eine Struktur auf, so dass es transparente und reflektierende Bereiche gibt. Somit kann über das Flächenverhältnis zwischen reflektierenden und transparenten Bereichen ein effektiver (d.h. gemittelter) Transmissionsgrad bzw. Reflexionsgrad für dieses Schichtdesign des Reflektors 129 eingestellt werden.

Um eine möglichst homogene Ausleuchtung über die gesamte Auflagefläche 104 zu realisieren, sollten die Strukturen im Metall der Reflektorschicht 129 kleiner sein als der Pixelmittenabstand der lichtsensitiven Elemente der Sensorschicht 115, damit die Strukturen nicht zu stark in dem von der Sensorschicht 115 aufgenommenen Bild erscheinen. Je breiter der Winkelbereich des abgestrahlten Beleuchtungslichts 110 der Leuchtschicht 116 ist, desto weniger Intensitätsschwankungen werden durch die Reflektorschicht 129 in der Sensorschicht 115 erzeugt.

Für eine möglichst homogene Ausleuchtung der Auflagefläche 104 können die Strukturen der Reflektorschicht 129 über ihre Fläche variieren. Insbesondere wird eine homogenere Ausleuchtung dann erzeugt, wenn der Reflexionsgrad in der Nähe der LEDs 125, die das Beleuchtungslicht 110 in die als Wellenleiter wirkende Leuchtschicht 116 einkoppeln, größer ist und dabei der Transmissionsgrad kleiner ist. Komplexe Verteilungsstrukturen sind so ausführbar, um in Abhängigkeit von dem Winkelspektrum der Beleuchtung, der Dicke des in der Leuchtschicht 116 ausgebildeten Wellenleiters und den Dicken der anderen Schichten im Schichtkörper 105 eine möglichst homogene Ausleuchtung der Auflagefläche 104 zu realisieren.

Sensorik

Damit das Bildaufnahmegerät 100 möglichst dünn und leicht realisiert werden kann, wird ein optisches Bildaufnahmekonzept verwendet, bei dem gänzlich auf konventionelle optisch abbildende Elemente, wie Linsen und Prismen, verzichtet wird. Die Sensorschicht 115 ist dabei in etwa so groß wie die Auflagefläche 104 und ermöglicht so eine 1:1-Abbildung der Objekte, die sich auf der Auflagefläche 104 befinden. Er detektiert dabei von der Leuchtschicht 116 sowohl Lichtanteile, die intern an der Auflagefläche 104 reflektiert werden, als auch diejenigen, die von den Objekten, wie Autopodien 112 oder Dokumenten 113, zurückgestreut werden. Er detektiert aber auch Lichtanteile des Umgebungslichtes 127, die direkt die Auflagefläche 104 passieren oder die durch das aufgelegte Objekt hindurch die Auflagefläche 104 und die Schutzschicht 114 passieren.

Die Sensorschicht 115 ist bevorzugt auf Basis von TFT-Technologie ausgeführt. Diese ermöglicht es, einerseits großflächige Sensoren und andererseits Substratmaterialien abseits des Halbleiters Silizium, im Gegensatz zu CCD- oder CMOS-Technologie, zu verwenden. Somit ist ein für das visuelle Wellenlängenspektrum transparentes Substrat möglich. Bevorzugt wird für die Sensorschicht 115 Glas als Substratmaterial verwendet.

Die Sensorschicht 115 besteht aus einem zweidimensionalen regelmäßigen Pixelarray. Das Pixelarray weist lichtsensitive Bereiche 120 und transparente Bereiche 121 auf. Die lichtsensitiven Bereiche 120 sind bevorzugt Photodioden. Durch die transparenten Bereiche 121 und durch die Verwendung eines transparenten Substrates ist die gesamte Sensorschicht 115 im Mittel transparent. Der effektive Transmissionsgrad der Sensorschicht 115 liegt bei größer 10%, bevorzugt bei größer 20%.

Schutzschicht

Die Sensorschicht 115 wird durch eine Schutzschicht 114 vor Umgebungseinflüssen geschützt. Störende oder zerstörende Umgebungseinflüsse können mechanisch, chemisch und elektrisch wirken. Um mechanisch robust zu sein, muss die Schutzschicht 114 möglichst hart bzw. kratzfest sein. Die Aufnahme von Dokumenten 113 stellt hier eine Herausforderung dar, da diese härter sind als die Haut der Autopodien 112 und durch das Entlangführen des Dokuments 113 auf der Auflagefläche 104 harte Schmutzpartikel Kratzer erzeugen können. Eine Mohs-Härte von mindestens 6 ist hier erforderlich. Um weiterreichenden Schutz zu gewährleisten, wird eine Mohs-Härte von mindestens 7 bevorzugt. Für den chemischen Schutz muss die Sensorschicht 115 hinreichend gekapselt sein, Feuchtigkeit, Putzmittel, etc. dürfen nicht auf die Sensorschicht 115 gelangen. Ebenso muss sie vor elektrischer Entladung geschützt sein. Ein Isolator, wie z.B. Glas, mit einer Dicke von mindestens 25 µm stellt hier einen hinreichenden Schutz sicher.

Ein bevorzugtes Schutzsystem für die Sensorschicht 115, das vor allen genannten Umgebungseinflüssen ausreichend schützt, stellt Dünnglas mit einer Dicke größer 25 µm dar. Es bietet eine sehr gute Kapselung, eine Mohs-Härte $\geq$ 6 und außerdem den notwendigen Schutz vor elektrischen Entladungen. Bevorzugt ist Glas größerer Dicke, um die mechanische Schlagfestigkeit und den Entladungsschutz weiter zu erhöhen. Für bessere Kratzfestigkeit ist gehärtetes Glas, Saphir oder mit Härteschichten beschichtetes Glas besonders bevorzugt. Eine solche Schutzkomponente wird auf die Sensorschicht 115 geklebt oder mit einem anderen Fügeprozess optisch verbunden. Ein Kleber 133 zwischen Schutzschicht 114 und Sensorschicht 115 bildet eine zusätzliche Schicht im Schichtkörper 105, wie in Fig. 7 gezeigt.

Umgebungslichtschutz

Neben dem intern reflektierten Licht 111 oder dem Streulicht 109, die beide von der internen Leuchtschicht 116 stammen, gelangt auch Umgebungslicht 127 auf die Sensorschicht 115, z.B. durch die Sonne, siehe dazu Fig. 8. Das Umgebungslicht 127 kann dabei direkt durch die Auflagefläche 104 die Sensorschicht 115 erreichen oder auch durch die Autopodien 112 oder das Dokument 113 hindurch. Letzteres kann zu Informationsverlust führen, falls die lichtsensitiven Bereiche 120 der Sensorschicht 115 gesättigt werden und somit keine Information mehr aufnehmen. Ein wirksamer Schutz kann hier ein Spektralfilter 128 sein. Dieses kann z. B. zwischen der Schutzschicht 114 und der Sensorschicht 115 angeordnet sein. Da bei der Dokumentenaufnahme das Dokument 113 selbst einen guten Umgebungslichtschutz bietet, gilt es vor allem einen wirksamen Umgebungslichtschutz für die Aufnahme der Autopodien 112 zu finden. Rotes Licht aus der Umgebung gelangt sehr gut durch menschliches Gewebe hindurch, daher wäre ein wirksames Spektralfilter 128 so ausgeführt, dass es rotes Licht weitgehend blockiert. Das Spektralfilter 128 kann dabei z. B. als Absorptionsfilter oder auch als Interferenzfilter ausgeführt sein.

Bei einer bevorzugten Ausführungsform wird das Spektralfilter 128 als Fluid in den Kleber 133 zwischen Schutzschicht 114 und Sensorschicht 115 eingebracht, sodass keine zusätzliche Schicht notwendig ist.

Bei einer weiteren speziellen Ausführungsform ist das Spektralfilter 128 strukturiert ausgeführt, sodass nur die lichtsensitiven Bereiche 120 der Sensorschicht 115 mit dem Spektralfilter 128 versehen sind, nicht aber die transparenten Bereiche 121. Somit kann Licht der Leuchtschicht 116, ohne spektral gefiltert zu werden, über die Auflagefläche 104 vom Benutzer wahrgenommen werden. Dies ermöglicht z.B. eine farbige Displaydarstellung, falls die Leuchtschicht 116 durch das Display 103, wie zu Fig. 3 beschrieben, ausgeführt ist.

Eine weitere wirksame Variante für einen Umgebungslichtschutz ist eine Umgebungslichtblende 130, wie in Fig. 9 und Fig. 10. Im Gegensatz zur spektralen Filterung funktioniert dieses Konzept auf Basis von winkelselektiver Filterung. Hierzu gibt es mindestens eine zusätzliche Schicht mit einer Umgebungslichtblende 130. Diese wird in einem Abstand, der in etwa einer Kantenlänge des lichtsensitiven Bereichs 120 entspricht, zu diesem angeordnet. Dadurch können Lichtanteile blockiert werden, die in Winkeln auf den lichtsensitiven Bereich 120 treffen, die im Winkelspektrum des Beleuchtungslichts 110 gar nicht vorkommen, jedoch durch das Umgebungslicht 110 entstehen. Zusätzlich kann eine weitere Schicht direkt auf dem lichtsensitiven Bereich 120 angeordnet werden, um dort noch gezielter ungewünschte Winkelbereiche zu blockieren.

Display / Nutzerführung / Interaktion

In einer bevorzugten Ausführungsform kann der Nutzer über das Display 103 mittels Berührung (Touchscreen) das Bildaufnahmegerät 100 bzw. den Bildaufnahmeprozess steuern. Das Display 103 neben der Auflagefläche 104 dient dazu Eingabeaufforderungen oder Korrekturvorschläge darzustellen. Korrekturvorschläge können z. B. Hinweise sein, dass die Autopodien 112 stärker oder schwächer aufgedrückt werden sollen, oder die Fingerstellung verändert werden soll.

Eine Displayfunktionalität direkt auf der Auflagefläche 104 durch die Ausführung der Leuchtschicht 116 als Display 103 oder durch eine Kombination von Display 103 und Sensorschicht 115 in einer Schicht ermöglicht eine direkte Interaktion mit dem Benutzer. Dadurch können Fehler bei der Auflage direkt an der richtigen Stelle angezeigt werden. Der Abrollvorgang bei der Aufnahme gerollter Fingerabdrücke kann über die Vorgabe von Position und Geschwindigkeit des Abrollens interaktiv unterstützt werden.

Stromversorgung

Die erfindungsgemäße Anordnung weist in ihrem mobilen Bildaufnahmegerät 100 außerdem einen Akku oder eine Batterie auf, damit sie vollständig kabellos betrieben werden kann. Im Falle eines Akkus kann dieser über eine externe Schnittstelle (z.B. USB) mittels eines Ladegerätes geladen werden. Das Konzept des Bildaufnahmegerätes 100, mit den verwendeten Komponenten und üblichen Stromsparfunktionen ohne eine Aufladung oder sonstige Kabelverbindung im Einsatz zu sein, kann vorzugsweise für einen ganzen Tag realisiert sein. Mit einer Dockingstation oder einem bereits oben erwähnten Wechselakku, kann diese Zeitspanne aber auch deutlich kürzer gewählt werden.

Verfahren

Das mobile Bildaufnahmegerät 100 ist mit einem weiteren elektronischen Gerät, entweder einem Mobiltelefon (Smartphone) 101, einem Tablet-PC 102 oder einem stationären Computer 106 mit Bildschirm 107 drahtlos verbunden. Über das Bildaufnahmegerät 100 werden Bilder von Dokumenten 113, insbesondere ID-Dokumenten, und Hautbereichen menschlicher Autopodien 112 aufgenommen und an das verbundene elektronische Gerät, ein Mobiltelefon 101, einen Tablet-PC 102 oder einen Computer 106 gesendet.

Das Senden erfolgt, mit einer Latenz im Bereich <1 s, als Livesequenz. Durch die Beschränkung der Bandbreite der drahtlosen Verbindung müssen die Bilder auf dem Bildaufnahmegerät 100 vor dem Senden reduziert werden.

Reduzieren des in dem Bildaufnahmegerät 100 aufgenommenen Bildes bezieht sich auf die Dateigröße. Bevorzugte Varianten die Dateigröße zu reduzieren sind z. B.:

    (a) Reduzieren der Auflösung (jedes n-te Pixel, jeder n-ten Zeile wird verworfen),
    (b) Reduzieren der Dynamik (Reduzieren der Anzahl der Graustufen, z. B. Konvertierung von 9-bit auf 8-bit),
    (c) Ausschneiden relevanter Bildinformation (Verwerfen von Bildteilen, die keine relevanten Informationen beinhalten),
    (d) Komprimieren (gängige Kompressionsalgorithmen, wie z.B. die verlustfreie png-Komprimierung).

Mindestens das jeweils letzte mit dem Bildaufnahmegerät 100 aufgenommene Bild wird als Vollbild (also mit voller Auflösung und vollem Dynamikumfang) auf diesem gespeichert vorgehalten, um bei einem OK-Signal der Qualitätsprüfung aus dem gekoppelten weiteren elektronischen Gerät 101, 102 oder 106 mit als Vollbild gesendet zu werden. Ältere Aufnahmen werden dabei gelöscht bzw. überschrieben.

Die als Livesequenz an das verbundene elektronische Gerät 101, 102 oder 106 gesendeten Daten werden von diesem Gerät bewertet. Eine Bewertung kann z.B. erfolgen anhand

    (a) der Analyse des Bildrauschens,
    (b) der Graustufenanalyse (Histogramm) und
    (c) der Kontrastanalyse (z.B. Berg-Tal-Kontrast des Fingerabdrucks).

Die Bewertung kann dabei z. B. mittels Vergleichs erfolgen. Wird ein Vergleichswert (Schwellwert) erreicht, wird ein Signal an das Bildaufnahmegerät 100 gesendet.

Eine bevorzugte Variante, bei der nur das jeweils letzte Vollbild im Bildaufnahmegerät 100 gespeichert wird, beinhaltet, dass das verbundene elektronische Gerät 101, 102 oder 106 immer das zuletzt aus der Livesequenz empfangene Bild bewertet. Erfüllt dieses Bild die Qualitätsanforderung, wird nach dem Senden des Signals an das Bildaufnahmegerät 100 das letzte gespeicherte Vollbild vom Bildaufnahmegerät 100 an das verbundene Gerät 101, 102 oder 106 gesendet. Dazu muss der Versand des letzten reduzierten Bildes, dessen Bewertung auf dem verbundenen Gerät 101, 102 oder 106 und der Empfang des Signals auf dem Bildaufnahmegerät 100 schneller erfolgen, als der zeitliche Abstand zweier Bilder der Livesequenz. Ansonsten wäre nach dem Empfang des Signals auf dem Bildaufnahmegerät 100 das gespeicherte Vollbild schon wieder mit einem neuen Vollbild überschrieben und somit das Vollbild, das mit dem verbundenen elektronischen Gerät 101,102 oder106 bewertet wurde, gelöscht.

Bei einer besonders bevorzugten Variante des Verfahrens werden mehrere Vollbilder im Bildaufnahmegerät 100 mit einer eindeutigen Kennung gespeichert. Die in der Livesequenz gesendeten reduzierten Bilder tragen auch diese Kennung. Die Kennung des Bildes, das auf dem verbundenen elektronischen Gerät 101, 102 oder 106 den Qualitätstest bestanden hat, wird an das Bildaufnahmegerät 100 gesendet. Letzteres sendet dann wiederum das Vollbild an das verbundene elektronische Gerät 101, 102 oder 106.

Die beschriebenen Prozeduren können sich für verschiedene Aufnahmen entsprechend einer bestimmten Prozesskette (Workflow) wiederholen. Typisch ist z.B. der 4-4-2-Workflow. Dabei werden in einer ersten Bildaufnahme vier Finger der einen Hand (Autopodien 112), dann in einer zweiten Bildaufnahme die vier Finger 112 der zweiten Hand und danach als dritte Bildaufnahme die Daumen beider Hände (Autopodien 112) gescannt. Über das Display 103 des Bildaufnahmegerätes 100 erfolgt jeweils die Aufforderung zum Auflegen der entsprechenden Finger 112 sowie die Response, wenn der Qualitätscheck im gekoppelten weiteren elektronischen Gerät 101, 102 oder 106 erfolgt ist und die Qualitätskriterien erfüllt sind (z.B. grünes Häkchen im Display 103).

Auf dem verbundenen elektronischen Gerät 101, 102 oder 106 werden die Vollbilder weiterverarbeitet. Eine Verarbeitung kann hier die Fusion verschiedener Aufnahmen sein bzw. das Zusammenführen von Aufnahmen und Informationen, sowie das Komprimieren. Verarbeitete Bilder können über das verbundene elektronische Gerät 101, 102 oder 106 an Datenbanken oder Speichersysteme weitergeleitet werden oder auch mit lokal auf dem verbundenen elektronischen Gerät 101, 102 oder 106 gespeicherten Datenbanken verglichen werden.

Das Ergebnis eines Datenbankvergleiches (z. B. Treffer in einer Kriminaldatenbank) kann auf dem verbundenen Gerät 101, 102 oder 106 ausgewertet werden oder an das Bildaufnahmegerät 100 gesendet werden. Auch ein verdeckter Alarm am Bildaufnahmegerät 100 oder am gekoppelten weiteren elektronischen Gerät 101, 102 oder 106 ist möglich.

Das Bildaufnahmegerät 100 kann über das drahtlos verbundene weitere elektronische Gerät 101, 102 oder 106 gesteuert und überwacht werden (Überwachung der Aufnahmeprozedur, Sichtung und Kontrolle der Aufnahmedaten, Notlöschung von Daten bei Verlust, Sperren des Bildaufnahmegerätes 100, Interaktion mit dem Bildaufnahmevorgang). Die Steuerung und Überwachung kann sich dabei auch gleichzeitig auf mehrere drahtlose Bildaufnahmegeräte 100 erstrecken. Daten mehrerer Bildaufnahmegeräte 100 können so zusammengeführt, die Vorgänge effizient überwacht und die Daten gebündelt versendet werden. Über das drahtlos verbundene elektronische Gerät 101, 102 oder 106 können wiederum weitere Daten ergänzt werden, z. B. über eine Tastatur oder auch ein Foto, z. B. vom Gesicht. Diese werden dann mit dem Fingerabdruck und/oder Dokumentendaten und/oder Unterschriftsdaten zusammengefasst und versendet oder ausgewertet.

Andererseits kann auch das Bildaufnahmegerät 100 ein drahtlos verbundenes Gerät steuern und überwachen. Der Versand von Daten mittels des verbundenen elektronischen Gerätes 101, 102 oder 106 (das wiederum mit Datenbanken verbunden ist, z.B. über das Internet) kann über das Bildaufnahmegerät 100 ausgelöst werden. Dafür kann das verbundene elektronische Gerät 101, 102 oder 106 der erfindungsgemäßen Anordnung den Status seiner Verbindung mit einer Datenbank mitteilen (Internetverbindung, Sicherheitslevel, Batteriestatus). Auswertungsergebnisse können der erfindungsgemäßen Anordnung gesendet werden, so kann z. B. ein verdeckter Alarm ausgelöst werden. So kann z. B. ein Grenzbeamter, während er die Daten eines Reisenden aufnimmt, vor diesem gewarnt werden, falls er als Krimineller registriert ist.

Ausführungsbeispiel 1

Ein typisches Einsatzgebiet für die mobile Anwendung der erfindungsgemäßen Anordnung und des erfindungsgemäßen Verfahrens ist das Passieren einer Landesgrenze, z.B. die Grenze zwischen den USA und Mexiko, im privaten Grenzverkehr per Kraftfahrzeug (Auto).

Das Auto ist beispielsweise mit vier Insassen besetzt. Die vier Reisenden sollen über den Fingerabdruck von jeweils zehn flach aufgenommenen Fingern 112 identifiziert werden. Außerdem soll in diesem Kontrollablauf der Führerschein mit aufgenommen werden.

Am Grenzübergang befindet sich ein Grenzhäuschen, in dem ein Grenzpolizist sitzt. Auf der Straße befindet sich eine Schranke, vor der das Auto hält. Der Grenzpolizist hat das mobile Bildaufnahmegerät 100 und einen PC 106 als gekoppeltes weiteres elektronisches Gerät in seinem Grenzhäuschen. Der PC 106 und das Bildaufnahmegerät 100 sind drahtlos über WLAN miteinander verbunden, wobei der PC 106 wiederum über das Internet mit der US-IDENT (Fingerabdruckdatenbank des DHS) verbunden ist.

Der Polizist lässt sich die Führerscheine aushändigen. Er schaltet den Modus zum Aufnehmen der ID-Dokumente 113 am mobilen Bildaufnahmegerät 100 ein und nimmt nacheinander Bilder der ID-Dokumente 113 der Insassen auf. Danach aktiviert er den Modus zur Aufnahme von Fingerabdrücken und reicht das mobile Bildaufnahmegerät 100 in das Auto. Die Insassen nehmen nacheinander jeweils Abdrücke ihrer zehn Finger 112 auf. Wann welche Finger 112 aufgenommen werden sollen, wird über ein Display 103 am Bildaufnahmegerät 100 kommuniziert. Der Polizist im Grenzhäuschen überwacht den Aufnahmevorgang am PC 106. Er kann dabei die Live-Bilder sehen und z.B. eine Wiederholung bestimmter Aufnahmen auf dem Display 103 des Bildaufnahmegerätes 100 anfordern.

Das Ablaufschema für die Aufnahme der Fingerabdrücke ist im beschriebenen Szenario typischerweise 4-4-2: zuerst vier Finger der einen Hand, dann die vier Finger der anderen Hand, zuletzt beide Daumen. Es werden hier also pro Person drei Bilder aufgenommen.

Sind alle Aufnahmen erfolgreich abgeschlossen, werden die Fingerabdruckdaten mit der Datenbank verglichen. Die Datenbank sendet ein Ergebnis an den PC 106, auf dessen Bildschirm 107 es angezeigt wird.

Dieser Identifikationsablauf ist wesentlich sicherer als Einzelfingeraufnahmen, die heute meist benutzt werden. Eine falsche Zuordnung der Finger 112 durch eine falsche Reihenfolge bei der Aufnahme ist ausgeschlossen. Die Geschwindigkeit der beiden Vier-Finger-Aufnahmen und der Zwei-Daumen-Aufnahme ist größer als bei der Einzelfingeraufnahme, da nur drei anstelle von zehn Bildern aufgenommen werden. Ferner ist die Sicherheit für den Beamten höher, denn dieser muss das Grenzhäuschen für die Prozedur nicht verlassen. Die Datensicherheit ist hoch, da die Reisenden keinen direkten Zugang zum PC 106 bekommen und diesen somit auch nicht entwenden können. Auf dem mobilen Bildaufnahmegerät 100 werden keine Daten der Reisenden gespeichert, nachdem die Vollbilddaten der drei einzelnen Abdruckbilder an den PC 106 überspielt wurden. Die Kosten dieser Grenzkontrolle sind geringer als bei zwei separaten Geräten für die Dokumentenaufnahme und für Fingerabdruckaufnahmen.

Außerdem ist der Komfort für das Grenzpersonal deutlich erhöht. Der Beamte hat jederzeit Kontrolle über die Fingerabdruckaufnahme der Reisenden durch Spiegelung der Aufnahmeprozedur auf dem PC 106. Flächige Auflage der ID-Dokumente 113 auf der Auflagefläche 104 vereinfacht die Aufnahme und vermeidet Unschärfen, Reflexionen und Umgebungslichtprobleme im Vergleich zum Fotografieren der Dokumente 113. Die Reisenden müssen das Fahrzeug nicht verlassen, um die Aufnahme am Bildaufnahmegerät 100 durchzuführen.

Ausführungsbeispiel 2

Ein weiteres typisches Szenario für die Anwendung der erfindungsgemäßen Anordnung ergibt sich beispielsweise in Einzelhandelsgeschäften. Der Kunde möchte ein Produkt kaufen und dieses auch bezahlen. Der Verkäufer steht nicht an einer konventionellen Kasse, sondern bewegt sich frei im Geschäft. Er führt das mobile Bildaufnahmegerät 100 mit sich. Dieses wiederum ist drahtlos mit einem Tablet-PC 102 als gekoppeltes weiteres elektronisches Gerät zur Datenqualitätsprüfung und Verifikation der Personendaten verbunden.

Der Kunde zahlt beim Verkäufer mittels Kreditkarte, sein Fingerabdruck wird aufgenommen und er unterschreibt. Der Tablet-PC 102 ist mit der Kreditkartenbank verbunden. Der Verkäufer nimmt das Produkt, das der Kunde kaufen möchte, und macht eine Aufnahme von dessen Barcode mit dem erfindungsgemäßen Bildaufnahmegerät 100. Preis und Bezahlmethoden werden auf dem Display 103 des Bildaufnahmegeräts 100 angezeigt. Der Verkäufer wählt die Bezahlmethode mittels Touchscreen und nimmt ein Bild der Kreditkarte des Kunden auf und scannt dessen vier flache Fingerabdrücke einer Hand. Alle Aufnahmen des mobilen Bildaufnahmegerätes 100 werden an den Tablet-PC 102 übermittelt. Die Fingerabdruckdaten und die Kreditkartendaten werden über den Tablet-PC 102 an die Kreditkartenbank gesendet und dort gegen eine Datenbank geprüft. Die Datenbank sendet das Ergebnis der Prüfung an den Tablet-PC 102. Dieser sendet das Ergebnis an das mobile Bildaufnahmegerät 100, wo es angezeigt wird. Der Kunde bestätigt daraufhin die Zahlung durch seine Unterschrift auf dem mobilen Bildaufnahmegerät 100. Über den Tablet-PC 102 wird daraufhin der Druckvorgang eines Kassenbelegs für den Kunden eingeleitet.

Die Sicherheit beim beschriebenen Szenario ist deutlich erhöht, da die Aufnahme von mehreren Fingern sicherer ist als die Einzelfingeraufnahme, wie sie heute üblich ist. Auch durch die Erfassung von drei Zahlungskontrollfaktoren, Kreditkarte, Fingerabdruck und Unterschrift, wird die Sicherheit erhöht. Die Kreditkarte wird optisch ausgelesen, nicht berührungslos, das senkt das Risiko für Datendiebstahl. Der Tablet-PC 102 liegt an einem sicheren Platz, sodass er nicht entwendet werden kann. Das mobile Bildaufnahmegerät 100 enthält keine Daten von vorherigen Kunden. Kosten können gespart werden, da hier nur ein Gerät für die Aufnahme von Barcodes, Fingerabdrücken, Dokumenten und Unterschriften verwendet wird. Der Komfort erhöht sich, da der Kunde nicht an einer Warteschlange anstehen muss. Der Verkäufer kann den Verkaufsprozess aktiv von der Anbahnung bis zum Abschluss gestalten.

Ausführungsbeispiel 3

Ein weiterer typischer Anwendungsfall ist die mobile Grenzkontrolle in Zügen. Zum Beispiel in einem Zug mit Reisenden von Russland nach Finnland müssen Reisende mit Visa per Fingerabdruck (zehn flache Finger) und Visum (im Reisepass) identifiziert werden, wobei das Visum bestätigt werden muss. Der Grenzpolizist hat zwei Stunden Zeit alle Reisenden zu überprüfen.

Der Grenzpolizist hat das mobile Bildaufnahmegerät 100 und ein Mobiltelefon 101 (Smartphone) als weiteres elektronisches Gerät für den Datenworkflow. Das Mobiltelefon 101 ist mit dem mobilem Bildaufnahmegerät 100 über Bluetooth verbunden. Das Mobiltelefon 101 wiederum ist mit EU-VIS (Visadatenbank der EU) verbunden.

Der Polizist nimmt die personellen Daten der Reisenden mit dem Mobiltelefon 101 auf und aktiviert die Fingerabdruck-/Dokumentenaufnahme auf dem Mobiltelefon 101, wodurch das verbundene mobile Bildaufnahmegerät 100 in den entsprechenden Modus schaltet, und das Mobiltelefon 101 wird in der Uniformjacke des Polizisten verstaut. Der Polizist nimmt zehn flache Finger 112 jedes Reisenden in drei Schritten (4-4-2) und danach das Visum mit der großflächigen optischen Sensorschicht 115 des mobilen Bildaufnahmegerätes 100 auf. Das Mobiltelefon 101 empfängt die Fingerabdruck- und Visadaten (Dokumentenabbild) und sendet sie an die Datenbank. Die Datenbank vergleicht die Daten mit den gespeicherten Daten und sendet das Ergebnis an das Mobiltelefon 101. Bei einem unbedenklichen Ergebnis sendet das Mobiltelefon 101 das Ergebnis weiter an das mobile Bildaufnahmegerät 100 und dieses stellt das Ergebnis auf dem Display 103 dar. Ist ein Problem bei der Datenbanküberprüfung festgestellt worden, erzeugt das Mobiltelefon 101 einen stillen Alarm' oder sendet eine Fehlermeldung auf das Bildaufnahmegerät 100.

Ein Vorteil ist die Aufnahme von zehn Fingern 112 anstatt der bisherigen Einzelfingeraufnahme. Die Zehn-Finger-Prozedur benötigt nur drei Aufnahmen (4-4-2), der Ablauf ist somit schneller als bei sequentieller Bildaufnahme. Für den Beamten bietet das Verfahren mehr Sicherheit, da er bei gleichzeitiger Nutzung zweier Geräte immer nur ein Gerät bedienen muss und somit eine Hand frei hat. Außerdem gilt Sicherheit für die Daten: Das Mobiltelefon 101 kann schwerlich entwendet werden, es findet keine Speicherung der Fingerabdruck- und mobilen Daten auf dem mobilen Bildaufnahmegerät 100 statt. Ein weiterer Vorteil liegt ebenfalls in den Kosten, da nur ein Gerät für Fingerabdruck und Dokumentenaufnahme anstatt zwei Geräten nötig ist. Die flächige Auflage der ID-Dokumente 113 (Reisepässe und Visa) vereinfacht die Aufnahme, vermeidet Unschärfen, Reflexionen und Umgebungslichtprobleme im Vergleich zu einer Aufnahme mit einer konventionellen Kamera (z.B. Smartphone-Kamera).

Bezugszeichenliste

100 Bildaufnahmegerät
101 Mobiltelefon (Smartphone)
102 Tablet-PC
103 Display
104 Auflagefläche
105 Schichtkörper
106 (stationärer) Computer (PC)
107 Bildschirm
108 drahtlose Verbindung
109 Streulicht
110 Beleuchtungslicht
111 (intern) reflektiertes Licht
112 Autopodium (Finger), Hautabdruck
113 Dokument
114 Schutzschicht
115 Sensorschicht
116 Leuchtschicht
117 (elektronische) Steuer- und Datenverarbeitungseinheit
118 Tal
119 Berg
120 lichtsensitiver Bereich
121 transparenter Bereich
122 Lichtquelle (zur Beleuchtung von Autopodien 112)
123 Luftspalt
124 Lichtquelle (zur Beleuchtung von Dokumenten 113)
125 LED (Leuchtdiode)
126 Lichtausbreitung im Wellenleiter
127 Umgebungslicht (Sonne)
128 Spektralfilter
129 Reflektor(schicht)
130 Umgebungslichtblende
132 Pixelaperturblende
133 Kleber (zwischen Schutzschicht 114 und Sensorschicht 115)

**Patentansprüche**

1. Anordnung zur optischen Aufnahme von lebenden Hautbereichen menschlicher Autopodien und von Dokumenten, umfassend:

a) ein mobiles Bildaufnahmegerät (100) mit einer internen Stromversorgung, die eine Nutzung des Bildaufnahmegerätes (100) für eine gewünschte Nutzungsdauer ohne externe Stromzufuhr sicherstellt, und einer elektronischen Steuerungs- und Datenverarbeitungseinheit sowie einem Schichtkörper (105), der umfasst:

- eine Sensorschicht (115), in der lichtempfindliche Elemente in einem zweidimensionalen regelmäßigen Pixelraster angeordnet sind,
- eine transparente Schutzschicht (114) über dem zweidimensionalen Pixelraster der lichtempfindlichen Elemente der Sensorschicht (115), die eine parallel und in definiertem Abstand zu den lichtempfindlichen Elementen liegende Außenfläche des Schichtkörpers (105) aufweist, die eine Auflagefläche (104) für aufzunehmende Hautbereiche mehrgliedriger Autopodien (112) oder Dokumente (113) bereitstellt,
- eine flächige Lichtquelle, mit der Lichtanteile von der Lichtquelle ausgehend in Richtung der Sensorschicht (115) durch die Schutzschicht (114) hindurch in die auf der Auflagefläche (104) befindlichen Hautbereiche oder Dokumente (113) einkoppelbar sind, wobei alle Schichten des Schichtkörpers (105), die sich zwischen Lichtquelle und Auflagefläche (104) befinden, mindestens Anteile von Licht eines gewünschten Wellenlängenbereichs transmittieren, und

b) mindestens ein weiteres elektronisches Gerät (101, 102, 106), das von dem mobilen Bildaufnahmegerät (100) separiert ist,

**dadurch gekennzeichnet, dass**

- das mobile Bildaufnahmegerät (100) weiterhin mindestens ein Display (103) zur Anzeige einer Nutzerführung für den Anwender, das als Schicht des Schichtkörpers (105) ausgebildet ist, enthält,
- der Schichtkörper (105) unterhalb der Sensorschicht (115) durch die flächige Lichtquelle in Form einer Leuchtschicht (116) ergänzt ist, wobei die Leuchtschicht (116) ausgebildet ist zur Abstrahlung von Licht in unterschiedlichen Winkelbereichen:

   i) Licht in einem ersten Winkelbereich, sodass Lichtanteile in der Schutzschicht (114) an der Auflagefläche (104) intern reflektiert werden, um aufgelegte Hautbereiche (112) nach dem Prinzip der gestörten internen Totalreflexion aufzunehmen, und
   ii) Licht in einem zweiten Winkelbereich, sodass Lichtanteile durch die Auflagefläche (104) hindurch aufgelegte Dokumente (113) beleuchten, und

- die elektronische Steuerungs- und Datenverarbeitungseinheit (117) ausgebildet ist zum Ansteuern der Leuchtschicht (116), zur Bildauslesung, zum Vorverarbeiten der aufgenommenen Bilddaten und Reduzieren der Bilddaten für das drahtlose Versenden an das weitere elektronische Gerät (101, 102, 106), und
- das weitere elektronische Gerät (101, 102, 106) über eine Schnittstelle zur drahtlosen Datenübertragung und Kommunikation mit dem mobilen Bildaufnahmegerät (100) gekoppelt ist und zur Bilddatenverarbeitung mit Qualitätsbewertung der vom mobilen Bildaufnahmegerät (100) gesendeten Bilddaten derart ausgebildet ist, um als Ergebnis eine Aufforderung entweder zu einer weiteren Bildaufnahme oder, bei Gutbewertung der Bildqualität, zur Übermittlung von Vollbilddaten des aufgenommenen Bildes an das mobile Bildaufnahmegerät (100) zu senden, und zum Bilddatenmanagement eingerichtet ist, um übertragene Vollbilddaten zu speichern oder weiterzuleiten.

2. Anordnung nach Anspruch 1, **dadurch gekennzeichnet, dass** das Bildaufnahmegerät (100) zwei schichtförmige Lichtquellen (122, 124) aufweist, eine erste Lichtquelle (122) zur Beleuchtung für Aufnahmen von Hautabdrücken (112) nach dem Prinzip der gestörten internen Totalreflexion und eine zweite Lichtquelle (124), um Bilder von Dokumenten (113) aufzunehmen.

3. Anordnung nach Anspruch 1, **dadurch gekennzeichnet, dass** die Sensorschicht (115) des Bildaufnahmegerätes (100) transparente Bereiche aufweist, sodass ein Anteil von mindestens 10% des Lichtes der Leuchtschicht (116) die Sensorschicht (115) passieren kann.

4. Anordnung nach Anspruch 1, **dadurch gekennzeichnet, dass** das gekoppelte weitere elektronische Gerät eines aus der Gruppe Mobiltelefon (101), Tablet-PC (102), Laptop, stationärer Computer (106) ist.

5. Anordnung nach Anspruch 1, **dadurch gekennzeichnet, dass** das gekoppelte weitere elektronische Gerät (101, 102, 106) ein Display zum Anzeigen der mit dem Bildaufnahmegerät (100) aufgenommenen Bilder aufweist, um den Aufnahmevorgang in Echtzeit an dem weiteren gekoppelten elektronischen Gerät (101, 102, 106) anzeigen zu können.

6. Anordnung nach Anspruch 1, **dadurch gekennzeichnet, dass** im mobilen Bildaufnahmegerät (100) eine Stromversorgung vorhanden ist, die mindestens eine austauschbare Primärbatterie oder einen aufladbaren Akkumulator aufweist.

7. Anordnung nach Anspruch 1, **dadurch gekennzeichnet, dass** das mindestens eine Display (103) zur Anzeige der Information zur Nutzerführung in dem mobilen Bildaufnahmegerät (100) parallel zur Sensorschicht (115) auf deren von der Schutzschicht (114) abgewandten Seite angeordnet ist, sodass Informationen des Displays (103) durch die Sensorschicht (115) und die Schutzschicht (114) hindurch über der Auflagefläche (104) vom Nutzer wahrgenommen werden können.

8. Anordnung nach Anspruch 1, **dadurch gekennzeichnet, dass** das mindestens eine Display (103) des Bildaufnahmegerätes (100) sich neben der Auflagefläche (104) befindet, sodass Nutzerinformationen dargestellt und vom Nutzer gesehen werden können, auch wenn die Auflagefläche (104) mit Autopodien (112) oder einem Dokument (113) belegt ist.

9. Anordnung nach Anspruch 1, **dadurch gekennzeichnet, dass** im Bildaufnahmegerät (100) zusätzlich eine Kamera nebst Optik vorhanden ist, um ein Foto vom Gesicht des Nutzers aufzunehmen.

10. Anordnung nach Anspruch 1 **dadurch gekennzeichnet, dass** das mindestens eine Display (103) des Bildaufnahmegerätes (100) eine Touchfunktion enthält, mit der das mobile Bildaufnahmegerät (100) gesteuert werden kann.

11. Verfahren zur optischen Aufnahme von lebenden Hautbereichen menschlicher Autopodien und von Dokumenten mit einer optischen Anordnung nach einem der vorherigen Ansprüche, enthaltende Schritte:

- Aufforderung zum Auflegen mindestens eines mehrgliedrigen Autopodiums (112) oder eines Dokumentes (113) auf eine Auflagefläche (104) eines mobilen Bildaufnahmegerätes (100) mittels Anzeige auf einem Display (103) des mobilen Bildaufnahmegerätes (100),
- Auflegen des Autopodiums (112) oder eines Dokumentes (113) auf der Auflagefläche (104) des mobilen Bildaufnahmegerätes (100),
- Ansteuern mindestens einer flächigen Lichtquelle (116; 122, 124) in einem Beleuchtungsmodus, in dem Licht entweder zur Aufnahme von Hautabdrücken (112) mittels gestörter interner Totalreflexion oder zur Aufnahme von Dokumenten (113) in unterschiedlichen Winkelbereichen abgestrahlt wird,
- Aufnehmen von Bildern der Hautabdrücke des aufgelegten Autopodiums (112) oder des aufgelegten Dokuments (113) mit einer Sensorschicht (115) des mobilen Bildaufnahmegerätes (100),
- Speichern von Bilddaten eines aufgenommenen Bildes im mobilen Bildaufnahmegerät (100),
- Vorverarbeiten der Bilddaten des aufgenommenen Bildes und Reduzieren der Bilddaten im mobilen Bildaufnahmegerät (100),
- Versenden der reduzierten Bilddaten des aufgenommenen Bildes vom Bildaufnahmegerät (100) zu einem drahtlos gekoppelten weiteren elektronischen Gerät (101, 102, 106),
- Weiterverarbeiten der Bilddaten zur Qualitätsprüfung in dem gekoppelten weiteren elektronischen Gerät (101, 102, 106),
- Übermittlung des Ergebnisses der Qualitätsprüfung mit Aufforderung an das mobile Bildaufnahmegerät (100) zu einer weiteren Bildaufnahme oder, bei Gutbewertung der Bildqualität, zur Übermittlung von Vollbilddaten des vom Bildaufnahmegerät (100) aufgenommenen Bildes,
- Speichern oder Weiterversenden der übertragenen Vollbilddaten durch das weitere elektronische Gerät (101, 102, 106).

12. Verfahren nach Anspruch 11, enthaltend folgende weitere Schritte:

- Bewertung von sukzessive mit dem Bildaufnahmegerät (100) aufgenommenen Bildern mittels einer Bewertungssoftware innerhalb des gekoppelten weiteren elektronischen Gerätes (101, 102, 106),
- Versenden eines Signals vom weiteren elektronischen Gerät (101, 102, 106) an das Bildaufnahmegerät (100) als Auslöser zum Versenden von Vollbilddaten eines zuletzt aufgenommenen Bildes, wenn die Bewertungssoftware des weiteren elektronischen Gerätes (101, 102, 106) die Qualität des zuletzt aufgenommenen Bildes als gut bewertet hat,
- Versenden der Vollbilddaten des zuletzt aufgenommenen Bildes von Hautabdrücken der auf der Auflagefläche aufgelegten Autopodien (112) oder des aufgelegten Dokumentes (113) vom Bildaufnahmegerät (100) zum gekoppelten weiteren elektronischen Gerät (101, 102, 106).

13. Verfahren nach Anspruch 11, enthaltend folgende weitere Schritte:

- Bewertung von sukzessive mit dem Bildaufnahmegerät (100) aufgenommenen Bildern einer definierten Bildsequenz mittels einer Bewertungssoftware innerhalb des gekoppelten weiteren elektronischen Gerätes (101, 102, 106),
- Versenden eines Signals vom weiteren elektronischen Gerät (101, 102, 106) an das Bildaufnahmegerät (100) als Auslöser zum Versenden von Vollbilddaten eines ausgewählten Bildes der zuvor aufgenommenen Bildsequenz, wenn die Bewertungssoftware des weiteren elektronischen Gerätes (101, 102, 106) ein Bild der zuvor aufgenommenen Bildsequenz als qualitativ bestes Bild der Bildsequenz aus mehreren mit gut bewerteten Bildern ausgewählt hat,
- Versenden der Vollbilddaten des qualitativ besten Bildes der zuvor aufgenommenen Bildsequenz von Hautabdrücken der aufgelegten Autopodien (112) oder des aufgelegten Dokumentes (113) vom Bildaufnahmegerät (100) an das gekoppelte weitere elektronische Gerät (101, 102, 106).

**14.** Verfahren nach Anspruch 11, enthaltend folgende weitere Schritte

- Bewertung von sukzessive mit dem Bildaufnahmegerät (100) aufgenommenen Bildern einer definierten Bildsequenz mittels einer Bewertungssoftware innerhalb des gekoppelten weiteren elektronischen Gerätes (101, 102, 106),
- Versenden eines Signals vom weiteren elektronischen Gerät (101, 102, 106) an das Bildaufnahmegerät (100) als Auslöser zum Versenden von Vollbilddaten eines ausgewählten Bildes der zuvor aufgenommenen Bildsequenz, wenn die Bewertungssoftware des weiteren elektronischen Gerätes (101, 102, 106) ein Bild der zuvor aufgenommenen Bildsequenz als qualitativ bestes Bild der Bildsequenz aus allen qualitativ unzureichend klassifizierten Bildern ausgewählt hat,
- Versenden der Vollbilddaten des qualitativ besten Bildes der zuvor aufgenommenen Bildsequenz von Hautabdrücken der aufgelegten Autopodien (112) oder des aufgelegten Dokumentes (113) vom Bildaufnahmegerät (100) an das gekoppelte weitere elektronische Gerät (101, 102, 106).

**15.** Verfahren nach Anspruch 11, enthaltend folgende weitere Schritte

- Versenden mindestens eines durch das Bildaufnahmegerät (100) aufgenommenen Bildes über das gekoppelte weitere elektronische Gerät (101, 102, 106) an eine verbundene Datenbank für eine Überprüfung einer Personenidentität oder Dokumentengültigkeit,
- Empfang des Ergebnisses der Überprüfung auf dem gekoppelten weiteren elektronischen Gerät (101, 102, 106) und Weiterleitung an das Bildaufnahmegerät (100), wenn die Überprüfung ein positives Ergebnis geliefert hat.

**16.** Verfahren nach Anspruch 11, enthaltend folgende weitere Schritte

- Versenden mindestens eines durch das Bildaufnahmegerät (100) aufgenommenen Bildes über das gekoppelte weitere elektronische Gerät (101, 102, 106) an eine verbundene Datenbank für eine Überprüfung einer Personenidentität oder Dokumentengültigkeit,
- Empfang des Ergebnisses der Überprüfung auf dem gekoppelten weiteren elektronischen Gerät (101, 102, 106) und Auslösung eines stillen Alarms' auf dem gekoppelten weiteren elektronischen Gerät (101, 102, 106), wenn die Überprüfung ein negatives Ergebnis geliefert hat.

**Claims**

**1.** Arrangement for optical recording of living skin areas of human autopodia and of documents, comprising:

a) a mobile image recording device (100) having an internal power supply, which ensures the use of the image recording device (100) for a desired period of use without external power supply, and an electronic control and data processing unit, as well as a layered body (105) comprising:

- a sensor layer (115) in which light-sensitive elements are arranged in a two-dimensional regular pixel grid,
- a transparent protective layer (114) over the two-dimensional pixel grid of the light-sensitive elements of the sensor layer (115), which has an outer surface of the layered body (105) lying parallel to and at a defined distance from the light-sensitive elements, and provides a placement surface (104) for skin areas of multi-joint autopodia (112) or documents (113) to be recorded,
- a planar light source with which portions of light can be coupled from the light source in the direction of the sensor layer (115) through the protective layer (114) into the skin areas or documents (113) located on the placement surface (104), wherein all layers of the layered body (105) located between the light source and the placement surface (104) transmit at least components of light of a desired wavelength range, and

b) at least one further electronic device (101, 102, 106) which is separate from the mobile image recording device (100),

**characterized in that**

- the mobile image recording device (100) further comprises at least one display (103) for displaying a user guide for the user, which is formed as a layer of the layered body (105),
- the layered body (105) is supplemented below the sensor layer (115) by the planar light source in the form of a luminescent layer (116), the luminescent layer (116) being designed to emit light in different angular ranges:

i) light in a first angular range so that portions of light in the protective layer (114) are internally reflected, according to the principle of disturbed total internal reflection, at the placement surface (104) to record skin areas (112) placed thereon, and
ii) light in a second angular range so that portions of light pass through the placement surface (104) to illuminate documents (113) placed thereon, and

- the electronic control and data processing unit (117) is configured to control the light emitting layer (116), to read out images, to preprocess the recorded image data and to reduce the image data for wireless transmission to the further electronic device (101, 102, 106), and
- the further electronic device (101, 102, 106) is coupled to the mobile image recording device (100) via an interface for wireless data transmission and communication and is provided for image data processing with quality evaluation of the image data transmitted by the mobile image recording device (100) in such a way that, as a result, a request is sent to the mobile image recording device (100) either for a further image recording or, in the case of the image quality being evaluated as good, for transmission of frame data of the recorded image, and is configured for image data management in order to store or forward transmitted frame data.

2. The arrangement according to claim 1, **characterized in that** the image recording device (100) comprises two layered light sources (122, 124), a first light source (122) for illumination for recording images of skin impressions (112) according to the principle of disturbed total internal reflection and a second light source (124) for recording images of documents (113).

3. The arrangement according to claim 1, **characterized in that** the sensor layer (115) of the image recording device (100) has transparent areas so that a proportion of at least 10% of the light from the luminescent layer (116) can pass through the sensor layer (115).

4. The arrangement according to claim 1, **characterized in that** the coupled further electronic device is one of the group mobile phone (101), tablet PC (102), laptop, stationary computer (106).

5. The arrangement according to claim 1, **characterized in that** the coupled further electronic device (101, 102, 106) comprises a display for displaying the images recorded by the image recording device (100) in order to be able to display the recording process in real time on the further coupled electronic device (101, 102, 106).

6. The arrangement according to claim 1, **characterized in that** a power supply is provided in the mobile image recording device (100) comprising at least one replaceable primary battery or rechargeable accumulator.

7. The arrangement according to claim 1, **characterized in that** the at least one display (103) for displaying the information for user guidance in the mobile image recording device (100) is arranged parallel to the sensor layer (115) on its side facing away from the protective layer (114), so that information of the display (103) can be perceived by the user through the sensor layer (115) and the protective layer (114) above the placement surface (104).

8. The arrangement according to claim 1, **characterized in that** the at least one display (103) of the image recording device (100) is located adjacent to the placement surface (104) so that user information can be displayed and seen by the user even when the placement surface (104) is occupied by autopodia (112) or a document (113).

9. The arrangement according to claim 1, **characterized in that** a camera with optics is additionally present in the image recording device (100) in order to record a photo of the user's face.

10. The arrangement according to claim 1, **characterized in that** the at least one display (103) of the image recording device (100) includes a touch function by which the mobile image recording device (100) can be controlled.

11. A method for optical recording of living skin skin areas of human autopodia and of documents with an optical arrangement according to any one of the preceding claims, comprising the steps of:

- requesting placement of at least one multi-joint autopod (112) or document (113) on a placement surface (104) of a mobile image recording device (100) by means of a display (103) on the mobile image recording device (100),
- placing the autopod (112) or a document (113) on the placement surface (104) of the mobile image recording device (100),
- controlling at least one planar light source (116; 122, 124) in an illumination mode in which light is emitted either for recording skin impressions (112) by means of disturbed total internal reflection or for recording documents (113) in different angular ranges,
- recording images of the skin impressions of the placed autopod (112) or the placed document (113) with a sensor layer (115) of the mobile image recording device (100),
- storing image data of a recorded image in the mobile image recording device (100),
- pre-processing the image data of the recorded image and reducing the image data in the mobile image recording device (100),

- sending the reduced image data of the recorded image from the image recording device (100) to a wirelessly coupled further electronic device (101, 102, 106),

- further processing of the image data for quality inspection in the coupled further electronic device (101, 102, 106),

- transmission of the result of the quality check with a request to the mobile image recording device (100) for a further image recording or, in the case of the image quality being evaluated as good, for transmission of frame data of the image recorded by the image recording device (100),

- storing or forwarding of the transmitted frame data by the further electronic device (101, 102, 106).

**12.** The method according to claim 11, comprising the following further steps:

- evaluating images successively recorded with the image recording device (100) by means of evaluation software within the coupled further electronic device (101, 102, 106),

- sending a signal from the further electronic device (101, 102, 106) to the image recording device (100) as a trigger for sending frame data of a last recorded image when the evaluation software of the further electronic device (101, 102, 106) has evaluated the quality of the last recorded image as good,

- sending the frame data of the last recorded image of skin impressions of the autopodia (112) placed on the placement surface or of the document (113) placed on the placement surface from the image recording device (100) to the coupled further electronic device (101, 102, 106).

**13.** The method according to claim 11, comprising the following further steps:

- evaluating images of a defined image sequence successively recorded with the image recording device (100) by means of evaluation software within the coupled further electronic device (101, 102, 106),

- sending a signal from the further electronic device (101, 102, 106) to the image recording device (100) as a trigger for sending frame data of a selected image of the previously recorded image sequence when the evaluation software of the further electronic device (101, 102, 106) has selected an image of the previously recorded image sequence as the best quality image of the image sequence from a plurality of images rated as good,

- sending the frame data of the best quality image of the previously recorded image sequence of skin impressions of the autopodia (112) in plae or the document (113) in place from the image recording device (100) to the coupled further electronic device (101, 102, 106).

**14.** The method according to claim 11, comprising the following further steps:

- evaluating images of a defined image sequence successively recorded with the image recording device (100) by means of evaluation software within the coupled further electronic device (101, 102, 106),

- sending a signal from the further electronic device (101, 102, 106) to the image recording device (100) as a trigger for sending frame data of a selected image of the previously recorded image sequence when the evaluation software of the further electronic device (101, 102, 106) has selected an image of the previously recorded image sequence as the best quality image of the image sequence from all images classified as being of insufficient quality,

- sending the frame data of the best quality image of the previously recorded image sequence of skin impressions of the autopodia (112) in place or the document (113) in place from the image recording device (100) to the coupled further electronic device (101, 102, 106).

**15.** The method according to claim 11, comprising the following further steps:

- sending at least one image recorded by the image recording device (100) via the coupled further electronic device (101, 102, 106) to a connected database for a check of a person's identity or the validity of a document,

- receiving the result of the check on the coupled further electronic device (101, 102, 106) and forwarding it to the image recording device (100) if the check has provided a positive result.

**16.** The method according to claim 11, comprising the following further steps:

- sending at least one image recorded by the image recording device (100) via the coupled further electronic device (101, 102, 106) to a connected database for a check of a person's identity or the validity of a document,

- receiving the result of the check on the coupled further electronic device (101, 102, 106) and triggering a 'silent alarm' on the coupled further

electronic device (101, 102, 106) if the check has provided a negative result.

## Revendications

**1.** Dispositif d'enregistrement optique de zones cutanées vivantes d'autopodes humains et documents, comprenant:

a) un appareil mobile de prise de vue (100) avec une alimentation électrique interne qui assure l'utilisation de l'appareil de prise de vue (100) pendant une durée d'utilisation souhaitée sans alimentation électrique externe, et une unité électronique de commande et de traitement de données, ainsi qu'un corps stratifié (105) qui comprend :

- une couche de détection (115) dans laquelle des éléments photosensibles sont disposés selon une grille de pixels régulière bidimensionnelle,
- une couche de protection transparente (114) sur la grille de pixels bidimensionnelle des éléments photosensibles de la couche de détection (115), qui présente une surface extérieure du corps de couche (105) parallèle aux éléments photosensibles et située à une distance définie de ceux-ci, ladite surface extérieure constituant une surface d'appui (104) pour des zones cutanées d'autopodes à plusieurs éléments (112) ou de documents (113) à enregistrer,
- une source lumineuse plane, avec laquelle des parts de lumière peuvent être couplées à partir de la source lumineuse en direction de la couche de détection (115) à travers la couche de protection (114) dans les zones cutanées ou documents (113) se trouvant sur la surface d'appui (104), toutes les couches du corps stratifié (105) qui se trouvent entre la source lumineuse et la surface d'appui (104) transmettant au moins des parts de lumière d'une plage de longueurs d'onde souhaitée, et

b) au moins un autre appareil électronique (101, 102, 106) séparé de l'appareil mobile de prise de vue (100),

**caractérisé en ce que**

- l'appareil mobile de prise de vue (100) comprend en outre au moins un écran (103) pour l'affichage d'un guidage de l'utilisateur, qui est conçu comme une couche du corps stratifié (105),
- le corps stratifié (105) est complété en dessous de la couche de détection (115) par la source lumineuse plane sous la forme d'une couche lumineuse (116), la couche lumineuse (116) étant conçue pour émettre de la lumière dans différentes plages angulaires :

i) de la lumière dans une première plage angulaire, de sorte que des parties de la lumière dans la couche protectrice (114) sont réfléchies intérieurement sur la surface d'appui (104) pour enregistrer des zones cutanées (112) mises en place selon le principe de la réflexion interne totale perturbée, et
ii) de la lumière dans une deuxième plage angulaire, de sorte que des parties de la lumière éclairent des documents (113) mis en place à travers la surface d'appui (104), et

- l'unité électronique de commande et de traitement de données (117) est conçue pour commander la couche lumineuse (116), pour la lecture d'images, pour le prétraitement des données d'image enregistrées et pour la réduction des données d'image pour l'envoi sans fil à l'autre appareil électronique (101, 102, 106), et
- l'autre appareil électronique (101, 102, 106) est couplé à l'appareil mobile de prise de vue (100) par l'intermédiaire d'une interface pour la transmission de données sans fil et la communication sans fil et est conçu pour le traitement de données d'image avec évaluation de la qualité des données d'image envoyées par l'appareil mobile de prise de vue (100) de manière à envoyer comme résultat une demande soit pour une autre prise de vue soit, en cas d'évaluation positive de la qualité de l'image, pour la transmission de données d'image complète de l'image enregistrée à l'appareil mobile de prise de vue (100), et est aménagé pour la gestion de données d'image afin de mémoriser ou de transmettre des données d'image complète transmises.

**2.** Dispositif selon la revendication 1, **caractérisé en ce que** l'appareil de prise de vue (100) comporte deux sources lumineuses (122, 124) en forme de couches, une première source lumineuse (122) pour l'éclairage pour des prises de vue d'empreintes cutanées (112) selon le principe de la réflexion interne totale perturbée et une deuxième source lumineuse (124) pour prendre des images de documents (113).

**3.** Dispositif selon la revendication 1, **caractérisé en ce que** la couche de détection (115) de l'appareil de prise de vue (100) présente des zones transparen-

tes, de sorte qu'une fraction d'au moins 10% de la lumière de la couche luminescente (116) peut traverser la couche de détection (115).

4. Dispositif selon la revendication 1, **caractérisé en ce que** l'autre appareil électronique couplé est un appareil choisi dans le groupe constitué par un téléphone mobile (101), une tablette PC (102), un ordinateur portable, un ordinateur fixe (106).

5. Dispositif selon la revendication 1, **caractérisé en ce que** l'autre appareil électronique couplé (101, 102, 106) comprend un écran pour afficher les images enregistrées par l'appareil de prise de vue (100) afin de pouvoir afficher le processus d'enregistrement en temps réel sur l'autre appareil électronique couplé (101, 102, 106).

6. Dispositif selon la revendication 1, **caractérisé en ce qu'**une alimentation électrique est présente dans l'appareil mobile de prise de vue (100), laquelle comprend au moins une batterie primaire remplaçable ou un accumulateur rechargeable.

7. Dispositif selon la revendication 1, **caractérisé en ce que** l'au moins un écran (103) pour l'affichage de l'information pour le guidage de l'utilisateur dans l'appareil mobile de prise de vue (100) est disposé parallèlement à la couche de détection (115) sur son côté opposé à la couche de protection (114), de sorte que des informations de l'écran (103) peuvent être perçues par l'utilisateur à travers la couche de détection (115) et la couche de protection (114) au-dessus de la surface d'appui (104).

8. Dispositif selon la revendication 1, **caractérisé en ce que** l'au moins un écran (103) de l'appareil de prise de vue (100) se trouve à côté de la surface d'appui (104), de sorte que des informations d'utilisateur peuvent être représentées et vues par l'utilisateur, même lorsque la surface d'appui (104) est occupée par des autopodes (112) ou un document (113).

9. Dispositif selon la revendication 1, **caractérisé en ce que** l'appareil de prise de vue (100) comporte en outre une caméra et une optique pour prendre une photo du visage de l'utilisateur.

10. Dispositif selon la revendication 1 **caractérisé en ce que** l'au moins un écran (103) de l'appareil de prise de vue (100) a une fonction tactile qui permet de commander l'appareil mobile de prise de vue (100).

11. Procédé d'enregistrement optique de zones cutanées vivantes d'autopodes humains et documents avec un dispositif optique selon l'une quelconque des revendications précédentes, comprenant les étapes suivantes :

- invitation à mettre en place au moins un autopode (112) à plusieurs éléments ou un document (113) sur une surface d'appui (104) d'un appareil mobile de prise de vue (100) au moyen d'un affichage sur un écran (103) de l'appareil mobile de prise de vue (100),
- mise en place de l'autopode (112) ou d'un document (113) sur la surface d'appui (104) de l'appareil mobile de prise de vue (100),
- commande d'au moins une source lumineuse plane (116 ; 122, 124) dans un mode d'éclairage dans lequel la lumière est émise soit pour l'enregistrement d'empreintes cutanées (112) au moyen d'une réflexion interne totale perturbée, soit pour l'enregistrement de documents (113) dans différentes plages angulaires,
- enregistrement, à l'aide d'une couche de détection (115) de l'appareil mobile de prise de vue (100), d'images des empreintes cutanées de l'autopode (112) mis en place ou du document (113) mis en place,
- stockage des données d'image d'une image enregistrée dans l'appareil mobile de prise de vue (100),
- prétraitement des données d'image de l'image enregistrée et réduction des données d'image dans l'appareil mobile de prise de vue (100),
- envoi des données d'image réduites de l'image enregistrée depuis l'appareil de prise de vue (100) vers un autre appareil électronique couplé sans fil (101, 102, 106),
- traitement ultérieur des données d'image pour le contrôle de la qualité dans l'autre appareil électronique couplé (101, 102, 106),
- transmission du résultat du contrôle de qualité avec demande à l'appareil mobile de prise de vue (100) d'en effectuer un autre enregistrement d'image ou, si la qualité de l'image est évaluée comme étant bonne, pour transmettre des données d'image complète de l'image enregistrée par l'appareil de prise de vue (100),
- stockage ou retransmission des données d'image complète transmises par l'autre appareil électronique (101, 102, 106).

12. Procédé selon la revendication 11, comprenant les étapes supplémentaires suivantes :

- évaluation d'images enregistrées successivement avec l'appareil de prise de vue (100) au moyen d'un logiciel d'évaluation à l'intérieur de l'autre appareil électronique couplé (101, 102, 106),
- envoi d'un signal depuis l'autre appareil électronique (101, 102, 106) vers l'appareil de prise de vue (100) en tant que déclencheur pour envoyer des données d'image complète d'une dernière image enregistrée lorsque le logiciel d'évaluation de l'autre appareil électronique (101, 102, 106) a évalué la qualité de la dernière image enregistrée comme étant bonne,
- envoi des données d'image complète de la dernière image enregistrée d'empreintes cutanées de l'autopode (112) ou du document (113) posé sur la surface d'appui, depuis l'appareil de prise de vue (100) vers l'autre appareil électronique couplé (101, 102, 106).

13. Procédé selon la revendication 11, comprenant les étapes supplémentaires suivantes :

- évaluation d'images enregistrées successivement avec l'appareil de prise de vue (100) d'une séquence d'images définie au moyen d'un logiciel d'évaluation à l'intérieur de l'autre appareil électronique couplé (101, 102, 106),
- envoi d'un signal depuis l'autre appareil électronique (101, 102, 106) vers l'appareil de prise de vue (100) en tant que déclencheur pour envoyer des données d'image complète d'une image sélectionnée de la séquence d'images précédemment enregistrée lorsque le logiciel d'évaluation de l'autre appareil électronique (101, 102, 106) a sélectionné une image de la séquence d'images précédemment enregistrée en tant qu'image de meilleure qualité de la séquence d'images parmi une pluralité d'images évaluées comme étant bonnes,
- envoi des données d'image complète de l'image de meilleure qualité de la séquence d'images précédemment enregistrées d'empreintes cutanées des autopodes mis en place (112) ou du document mis mis en place (113) par l'appareil de prise de vue (100) à l'autre appareil électronique couplé (101, 102, 106).

14. Procédé selon la revendication 11, comprenant les étapes supplémentaires suivantes :

- évaluation d'images enregistrées successivement avec l'appareil de prise de vue (100) d'une séquence d'images définie au moyen d'un logiciel d'évaluation à l'intérieur de l'autre appareil électronique couplé (101, 102, 106),
- envoi d'un signal depuis l'autre appareil électronique (101, 102, 106) vers l'appareil de prise de vue (100) en tant que déclencheur pour envoyer des données d'image complète d'une image sélectionnée de la séquence d'images précédemment enregistrée, lorsque le logiciel d'évaluation de l'autre appareil électronique (101, 102, 106) a sélectionné une image de la séquence d'images précédemment enregistrée en tant qu'image de meilleure qualité de la séquence d'images parmi toutes les images classées de qualité insuffisante,
- envoi des données d'image complète de l'image de meilleure qualité de la séquence d'images précédemment enregistrées d'empreintes cutanées des autopodes mis en place (112) ou du document mis en place (113) depuis l'appareil de prise de vue (100) vers l'autre appareil électronique couplé (101, 102, 106).

15. Procédé selon la revendication 11, comprenant les étapes supplémentaires suivantes :

- envoi d'au moins une image enregistrée par l'appareil de prise de vue (100), par l'intermédiaire de l'autre appareil électronique couplé (101, 102, 106), à une base de données connectée pour une vérification d'une identité de personne ou d'une validité de document,
- réception du résultat de la vérification sur l'autre appareil électronique couplé (101, 102, 106) et transmission à l'appareil de prise de vue (100) si la vérification a donné un résultat positif.

16. Procédé selon la revendication 11, comprenant les étapes supplémentaires suivantes :

- envoi d'au moins une image enregistrée par l'appareil de prise de vue (100), par l'intermédiaire de l'autre appareil électronique couplé (101, 102, 106), à une base de données connectée pour une vérification d'une identité de personne ou d'une validité de document,
- réception du résultat de la vérification sur l'autre appareil électronique couplé (101, 102, 106) et déclenchement d'une 'alarme silencieuse' sur l'autre appareil électronique couplé (101, 102, 106) si la vérification a donné un résultat négatif.

**Fig. 1**

**Fig. 2**

104

Please present
your four right
fingers

104                                                    114

116            105

**Fig. 3**

**Fig. 4**

EP 3 454 187 B1

Fig. 5

**Fig. 6**

**Fig. 7**

**Fig. 8**

**Fig. 9**

**Fig. 10**

| mobiles Bildaufnahmegerät | weiteres elektronisches Gerät |
|---|---|

Anzeigen verschiedener
Aufnahmemodi am Display

Auswahl des Aufnahmemodus

Fingerabdrücke | Dokumente | ••• | Barcode

Kontinuierliche Bildaufnahme

Aufforderung zum
Auflegen eines Objekts
auf der Auflagefläche

Auflegen eines Objekts

Warten auf das
nächste Bild

Versenden eines
reduzierten Bildes

Bildverarbeitung
Qualitätsanalyse
Displayanzeige

Nein — Bildqualität OK?

Ergebnis

Ja

Bereitstellen des
finalen Vollbildes

Vollbild

Bildverarbeitung
Displayanzeige

Nein — Aufnahmemodus
fertig?

Ja

Ja — weiterer Aufnahmemodus gewünscht?

Datenabgleich mit
lokaler oder
externer Datenbank

Nein

Standby

# Fig. 11

mobiles Bildaufnahmegerät

Auswahl des Aufnahmemodus
Fingerabdruckaufnahmen

Anzeigen verschiedener
Aufnahmeprozeduren

| 10-Finger-Abdrücke 4-4-2-Prozedur | 10-Finger-Abdrücke 4-2-4-Prozedur | 4-Finger-Abdruck einer Hand | ••• | 1-Finger-Abdruck einer Hand |

Auswahl der Aufnahmeprozedur

Kontinuierliche Bildaufnahme

# Fig. 12

```
┌─────────────────────────────────┐
│   mobiles Bildaufnahmegerät     │
└─────────────────────────────────┘

              ⋮ │ ⋮

┌─────────────────────────────────┐
│   Auswahl des Aufnahmemodus     │
└─────────────────────────────────┘
```

| Fingerabdrücke | | Dokumente | ••• |

| Aufforderung zum Auflegen eines Objekts auf der Auflagefläche | Aufforderung zum Auflegen eines Objekts auf der Auflagefläche |

| Auflegen von Fingern | Auflegen eines Dokuments |

| Einschalten einer Lichtquelle für die interne Totalreflexion | Einschalten einer diffusen Lichtquelle für Dokumentenaufnahme |

Kontinuierliche Bildaufnahme

| Ausschalten der Lichtquelle für die interne Totalreflexion | Ausschalten der diffusen Lichtquelle für Dokumentenaufnahme |

| Speichern des Fingerabdruckbildes | Speichern des Dokumentenbildes |

Datenverarbeitung zum Versenden an das weitere elektronische Gerät zur Qualitätsanalyse → reduziertes Bild →

⋮ │ ⋮

# Fig. 13

mobiles Bildaufnahmegerät | weiteres elektronisches Gerät | Lokale oder externe Datenbank

Vollbild

Speichern der verarbeiteten Vollbilddaten

Versenden der verarbeiteten Vollbilddaten

Vergleich der gesendeten Vollbilddaten mit Datenbank

Ergebnis

Ergebnis sicherheitsrelevant

Nein

Ja

Anzeige Ergebnis

Stiller Alarm / Speichern

**Fig. 14**

EP 3 454 187 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102015116026 A1
- US 6886104 B1
- US 8036431 B2
- US 8036431 B1
- US 7190817 B1
- US 7245765 B2
- US 20160110025 A1
- US 20160294557 A1
- WO 2017095880 A1